# EUROPEAN PATENT APPLICATION

(11) **EP 4 471 999 A1**
(43) Date of publication of application: **04.12.2024**
(21) Application number: 23746974.7
(22) Date of filing: 25.01.2023
(51) Int. Cl.: H01S 5/22, H01S 5/343

(54) **METHOD AND APPARATUS FOR MANUFACTURING LASER ELEMENT, LASER ELEMENT, AND ELECTRONIC DEVICE**

(30) Priority: 27.01.2022 JP 2022011292
(71) Applicant: Kyocera Corporation, Kyoto-shi, Kyoto 612-8501 (JP)
(72) Inventor: MURAKAWA, Kentaro, Kyoto-shi, Kyoto 612-8501 (JP); KAWAGUCHI, Yoshinobu, Kyoto-shi, Kyoto 612-8501 (JP); KAMIKAWA, Takeshi, Kyoto-shi, Kyoto 612-8501 (JP)
(74) Representative: Viering, Jentschura & Partner mbB Patent- und Rechtsanwälte
(86) International application number: PCT/JP2023/002206
(87) International publication number: WO 2023/145763

(57) **Abstract**

A manufacturing method for a laser element includes preparing a semiconductor substrate (10) including a base substrate (BK), a first growth suppressive part (5F) and a second growth suppressive part (5S) adjacent to each other with an opening portion (K) interposed therebetween, and a first semiconductor part (S1) having a longitudinal shape and positioned on the first growth suppressive part (5F) and the second growth suppressive part (5S) from the opening portion (K), forming, on the first semiconductor part (S1), a second semiconductor part (S2) including a ridge portion (RJ) positioned above the first growth suppressive part (5F), and scribing a portion, of a first laminate body (LB 1) including the first semiconductor part (S1) and the second semiconductor part (S2), positioned on a side where the ridge portion (RJ) is positioned.

## Description

### TECHNICAL FIELD

The present disclosure relates to a manufacturing method for a laser element.

### BACKGROUND OF INVENTION

As a technique for reducing threading dislocations in a gallium nitride (GaN)-based thin film, a selective growth technique such as an epitaxial lateral overgrowth (ELO) method is known (see, for example, Patent Document 1 or the like).

### CITATION LIST

### PATENT LITERATURE

Patent Document 1: JP 2013-251304 A

### SUMMARY

According to an aspect of the present disclosure, a manufacturing method for a laser element includes preparing a semiconductor substrate including a base substrate, a first growth suppressive part and a second growth suppressive part adjacent to each other with an opening portion interposed between the first growth suppressive part and the second growth suppressive part, and a first semiconductor part having a longitudinal shape and positioned on the first growth suppressive part and the second growth suppressive part from the opening portion, forming, on the first semiconductor part, a second semiconductor part including a ridge portion positioned above the first growth suppressive part, and scribing a portion of a first laminate body including the first semiconductor part and the second semiconductor part on a side where the ridge portion is positioned.

According to an aspect of the present disclosure, a manufacturing method for a laser element includes preparing a semiconductor substrate including a base substrate, a first growth suppressive part and a second growth suppressive part adjacent to each other with an opening portion interposed between the first growth suppressive part and the second growth suppressive part, and a first semiconductor part having a longitudinal shape and positioned on the first growth suppressive part and the second growth suppressive part from the opening portion, forming an intermediate portion including an active layer on the first semiconductor part, scribing a portion, of a laminate body including the first semiconductor part and the intermediate portion, positioned on the first growth suppressive part, and forming a ridge portion positioned above the first growth suppressive part on an upper layer side relative to the active layer.

According to an aspect of the present disclosure, a laser element includes a base semiconductor part, and a compound semiconductor part positioned on the base semiconductor part and including an active section, the base semiconductor part includes a first portion, a second portion, and a third portion positioned between the first portion and the second portion, the compound semiconductor part includes a ridge portion positioned above the first portion, and a scribing mark is provided in a portion on a side where the ridge portion is positioned.

### BRIEF DESCRIPTION OF THE DRAWINGS

FIG. 1 is a perspective view schematically illustrating a configuration of a laser body according to an embodiment of the present disclosure.
FIG. 2 is a perspective view schematically illustrating a configuration of an optical resonator included in the laser body.
FIG. 3 is a plan view illustrating a configuration of a compound semiconductor part.
FIG. 4 is a plan view illustrating a configuration of a compound semiconductor part.
FIG. 5 is a perspective view schematically illustrating a configuration of another example of the laser body according to the embodiment of the present disclosure.
FIG. 6 is a flowchart schematically illustrating a manufacturing method for the laser element according to the embodiment of the present disclosure.
FIG. 7 is a cross-sectional view schematically illustrating the manufacturing method for the laser element according to the embodiment of the present disclosure.
FIG. 8 is a perspective view schematically illustrating the manufacturing method for the laser element according to the embodiment of the present disclosure.
FIG. 9 is a perspective view illustrating a configuration of a laser body according to Example 1.
FIG. 10 is a cross-sectional view illustrating the configuration of the laser body according to Example 1.
FIG. 11 is a cross-sectional view illustrating the configuration of the laser element according to Example 1.
FIG. 12 is a perspective view illustrating the configuration of the laser element according to Example 1.
FIG. 13 is a flowchart schematically illustrating a manufacturing method for the laser element according to Example 1.
FIG. 14 is a cross-sectional view schematically illustrating the manufacturing method for the laser element according to Example 1.
FIG. 15 is a cross-sectional view illustrating a configuration example of a template substrate.
FIG. 16A is a cross-sectional view illustrating an example of a method of scribing and then cleaving a laminate body.
FIG. 16B is a cross-sectional view illustrating an example of a method of scribing and then cleaving the laminate body.
FIG. 17 is a perspective view schematically illustrating a laser substrate where a plurality of laser bodies are bonded to a support substrate.
FIG. 18 is a perspective view illustrating an example of the laser substrate having a bar shape after division.
FIG. 19 is a block diagram illustrating a manufacturing apparatus for the laser element according to Example 1.
FIG. 20 is a side view schematically illustrating another example of the manufacturing method for the laser element according to Example 1.
FIG. 21A is a schematic view illustrating an example of a track of a scribing tool.
FIG. 21B is a schematic view illustrating an example of a track of a scribing tool.
FIG. 22 is a cross-sectional view schematically illustrating a manufacturing method for a laser element according to Example 2.
FIG. 23 is a cross-sectional view illustrating an example of lateral growth of a first semiconductor part.
FIG. 24 is a cross-sectional view schematically illustrating a manufacturing method for a laser element according to Example 3.
FIG. 25 is a cross-sectional view schematically illustrating a manufacturing method for a laser element according to Example 4.
FIG. 26 is a flowchart schematically illustrating a manufacturing method for a laser element according to Example 5.
FIG. 27 is a cross-sectional view schematically illustrating the manufacturing method for the laser element according to Example 5.
FIG. 28 is a flowchart schematically illustrating a manufacturing method for a laser element according to Example 6.
FIG. 29 is a cross-sectional view schematically illustrating the manufacturing method for the laser element according to Example 6.
FIG. 30 is a cross-sectional view schematically illustrating a manufacturing method for a laser element according to Example 8.
FIG. 31 is a cross-sectional view schematically illustrating the manufacturing method for the laser element according to Example 8.

### DESCRIPTION OF EMBODIMENTS

An embodiment of the present disclosure will be described below with reference to the accompanying drawings. Note that the following description is for better understanding of the gist of the present disclosure and does not limit the present disclosure unless otherwise specified. Unless otherwise specified in this specification, "from A to B" representing a numerical value range means "A or more and B or less". Shapes and dimensions (length, width, and the like) of configurations illustrated in each of the drawings in the present application do not necessarily reflect actual shapes and dimensions, and are appropriately changed for clarification and simplification of the drawings. In this specification, a semiconductor laser (laser diode: LD) element may be simply referred to as a "laser element".

In the following description, first, a structure of a laser body included in the laser element according to the embodiment of the present disclosure will be outlined, and then a manufacturing method for the laser element according to the embodiment of the present disclosure will be described.

### Laser Body

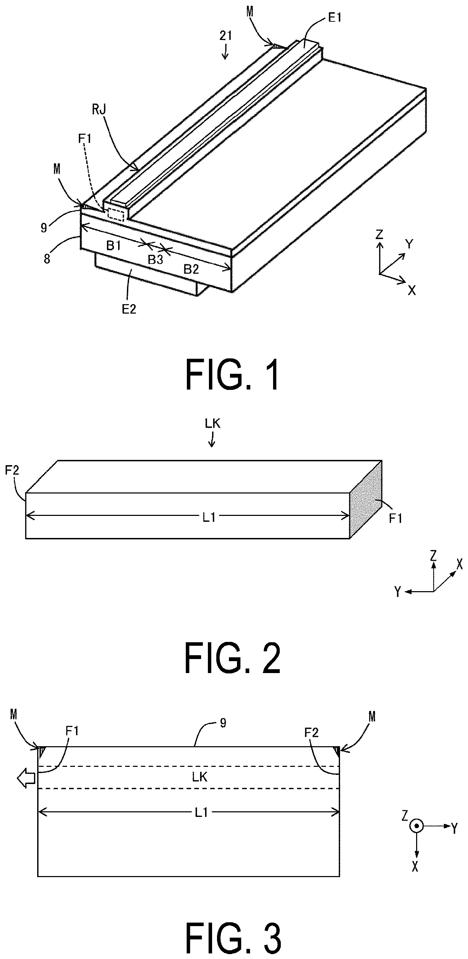

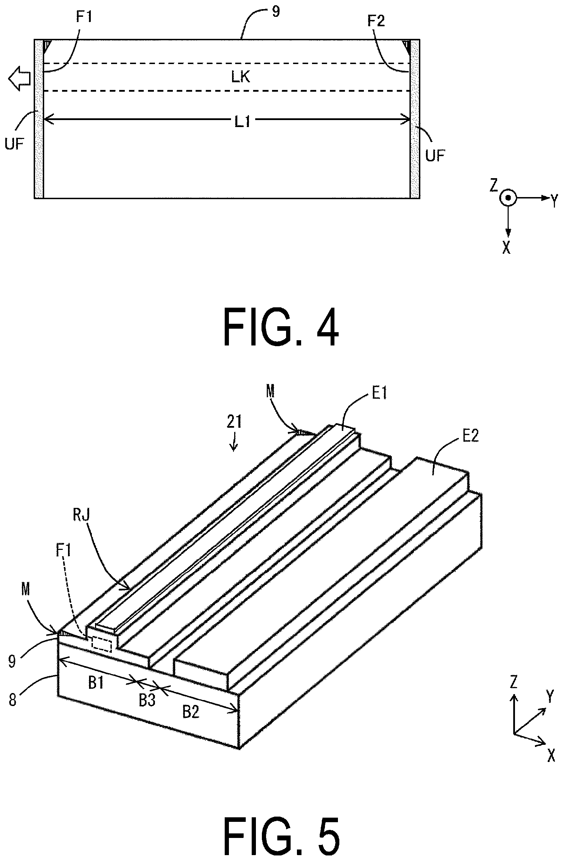

The laser body according to the embodiment of the present disclosure will be described below with reference to FIG. 1 to FIG. 4. FIG. 1 is a perspective view schematically illustrating a configuration of a laser body 21 according to the present embodiment. FIG. 2 is a perspective view schematically illustrating a configuration of an optical resonator LK included in the laser body 21. FIG. 3 and FIG. 4 are plan views illustrating a configuration of a compound semiconductor part 9. Note that in FIG. 1, for making illustration clearer and easier, the structure of each part is simply illustrated and the thickness of the compound semiconductor part 9, a ridge portion RJ, and the like are exaggerated. The laser body 21 may be positioned on a substrate for growth (for example, a template substrate 7, which will be described later) or may be mounted on a mounting substrate (also referred to as a submount), and the substrate for growth or the mounting substrate is omitted in FIG. 1 and the like.

As illustrated in FIG. 1 to FIG. 4, according to the present embodiment, the laser body 21 includes a base semiconductor part 8 and a compound semiconductor part 9 that is positioned on the base semiconductor part 8 and that includes the optical resonator LK. The base semiconductor part 8 may be a base semiconductor layer, and the compound semiconductor part 9 may be a compound semiconductor layer.

The base semiconductor part 8 includes a first portion B1, a second portion B2, and a third portion B3 positioned between the first portion B1 and the second portion B2. As will be described later, the third portion B3 may be a portion extending in a thickness direction (Z direction) and having a higher density of threading dislocations (threading dislocation density) than those of the first portion B1 and the second portion B2.

The compound semiconductor part 9 includes the ridge portion RJ positioned above the first portion B 1. The laser body 21 may include a scribing mark M at a portion on a side where the ridge portion RJ is positioned. The scribing mark M is a mark of scribing caused by scribing a laminate body having a longitudinal shape, which will be described later, and thus forming the laser body 21 by cleaving the laminate body. The scribing mark M will be described in detail later together with description of the manufacturing method for the laser element.

The resonator LK includes a pair of resonator end surfaces F1 and F2. At least one selected from the group consisting of the pair of resonator end surfaces F1 and F2 of the laser body 21 may be included in a cleaved surface of the compound semiconductor part 9. The resonator end surface F1 may be a surface on a side where a laser is to be emitted. As illustrated in FIG. 4, a reflector film UF (for example, a dielectric film) covering each of the resonator end surface F1 and the resonator end surface F2 may be provided.

Each of the base semiconductor part 8 and the compound semiconductor part 9 may contain a nitride semiconductor (for example, GaN-based semiconductor). The nitride semiconductor may be expressed by, for example, AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The base semiconductor part 8 may be of a doped type (for example, an n-type containing a donor) or a non-doped type (i-type).

The base semiconductor part 8 containing the nitride semiconductor can be formed by using an epitaxial lateral overgrowth (ELO) method. In the ELO method, for example, the base semiconductor part 8 is laterally grown on a template substrate including a selective growth mask (as will be described later). In this manner, a low-defect portion (the first portion B1 and/or the second portion B2) having a low threading dislocation density can be formed on the selective growth mask.

The laser body 21 includes a first electrode E1 and a second electrode E2 for supplying a current to the optical resonator LK. The first electrode E1 can be disposed so as to overlap the optical resonator LK in plan view in the thickness direction of the base semiconductor part 8. Note that the expression of "two members overlap each other" means that at least a part of one member overlaps the other member in plan view (including a perspective plan view) in a thickness direction of each member, and these members may or do not need to be in contact with each other.

In the laser body 21, a plurality of layers as the compound semiconductor part 9 are layered on the base semiconductor part 8, and a layering direction (thickness direction) thereof may be defined as the Z direction. In the following, in XYZ axes illustrated in FIG. 1 and the like, a positive side in the Z axis direction may be referred to as a "top side", and a negative side in the Z axis direction may be referred to as a "bottom side". In this specification, viewing a certain member from the Z direction, in other words, viewing the member with a line of sight parallel to the normal direction of the upper surface of the member on a substantially flat plate is referred to as "plan view" in some cases. This is the same or similar in the following description, and repeated description is omitted.

In FIG. 1, the first electrode E1 and second electrode E2 are provided on different sides with respect to the base semiconductor part 8, and the first electrode E1 and second electrode E2 overlap each other in plan view, which is called a double-sided electrode structure. However, the laser body 21 is not limited to such a configuration. As illustrated in FIG. 5, the laser body 21 may be provided with the first electrode E1 and second electrode E2 on the same side with respect to the base semiconductor part 8, and a configuration may be applicable in which the first electrode E1 and second electrode E2 do not overlap each other in plan view (single-sided two-electrode structure). The laser body 21 may be provided with the second electrode E2 such that the upper surface of the base semiconductor part 8 is partially exposed, and the second electrode E2 comes into contact with the exposed base semiconductor part 8. The second electrode E2 may be in contact with an n-type semiconductor part, which will be described later, included in the compound semiconductor part 9.

### Manufacturing Method for Laser Element

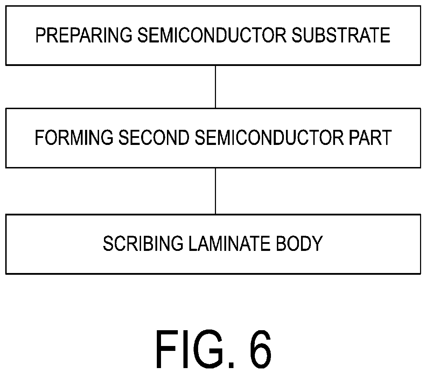

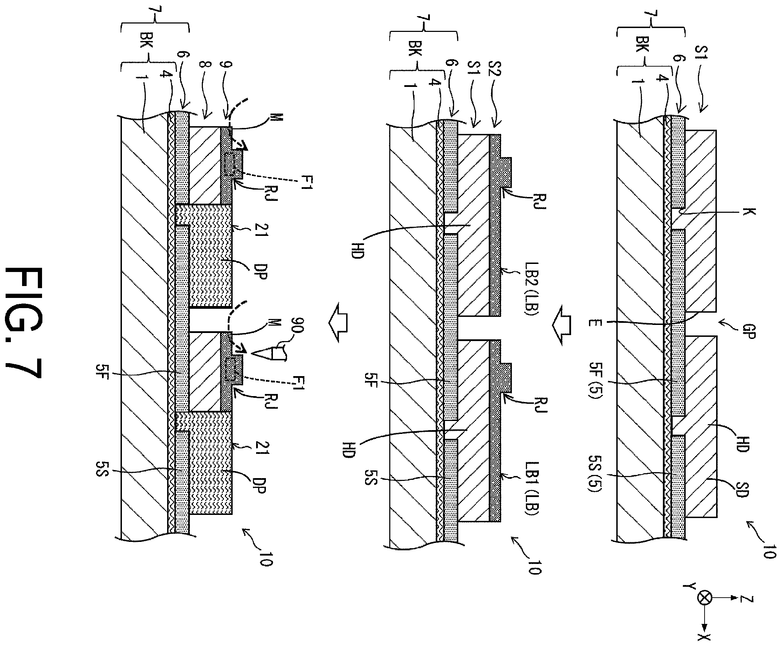

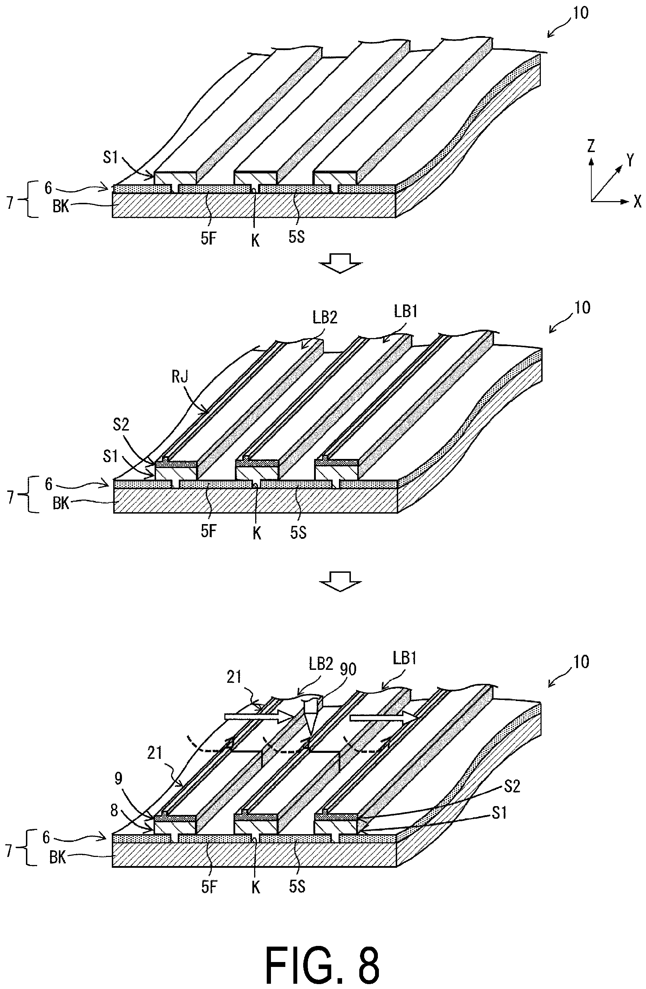

FIG. 6 is a flowchart schematically illustrating a manufacturing method for the laser element according to the embodiment of the present disclosure. FIG. 7 is a cross-sectional view schematically illustrating the manufacturing method for the laser element according to the present embodiment. FIG. 8 is a perspective view schematically illustrating the manufacturing method for the laser element according to the embodiment of the present disclosure. Note that In FIG. 7 and FIG. 8, for making illustration clearer and easier, the structure of each part is simplified and the thickness of the second semiconductor part S2, the ridge portion RJ, and the like are exaggerated.

As illustrated in FIG. 6 to FIG. 8, in the manufacturing method for the laser element according to the present embodiment, the following steps are performed. That is, first, a semiconductor substrate 10 is prepared. The semiconductor substrate 10 includes a base substrate BK, a first growth suppressive part 5F and a second growth suppressive part 5S adjacent to each other with an opening portion K interposed therebetween, and the first semiconductor part S1 having a longitudinal shape and positioned on the first growth suppressive part 5F and the second growth suppressive part 5S from the opening portion K. Then, the second semiconductor part S2 including the ridge portion RJ positioned above the first growth suppressive part 5F is formed on the first semiconductor part S1. Then, scribing is performed at a portion of a first laminate body LB 1 including the first semiconductor part S1 and the second semiconductor part S2 on the side where the ridge portion RJ is positioned. The first growth suppressive part 5F and the second growth suppressive part 5S may be a first mask portion and a second mask portion adjacent to each other with the opening portion K interposed therebetween.

The base substrate BK includes a main substrate 1 and an underlying portion 4 formed on the main substrate 1. A growth control pattern 6 (for example, a mask pattern) may be formed to include a plurality of opening portions K each of which has a longitudinal shape and extends in a Y direction (second direction) above the base substrate BK. In this specification, when the first growth suppressive part 5F and the second growth suppressive part 5S are not distinguished from each other, the first growth suppressive part 5F and the second growth suppressive part 5S may be collectively referred to as a growth suppressive part 5. The base substrate BK and the growth control pattern 6 may be collectively referred to as the template substrate 7. The growth suppressive part 5 may be a mask portion, and the growth control pattern 6 may be a mask pattern including the mask portion (growth suppressive part 5) and the opening portion K, but is not limited thereto. The opening portion K is a region without the growth suppressive part 5 in the growth control pattern 6, and the opening portion K is not necessarily surrounded by the growth suppressive part 5.

The underlying portion 4 in the base substrate BK includes a seed portion (not illustrated), and the first semiconductor part S1 can be formed by the ELO method with the seed portion exposed from the opening portion K serving as a starting point. In the present embodiment, the first semiconductor parts S1 may be formed such that the first semiconductor parts S1 grown from adjacent seed portions do not contact (meet) each other on the growth suppressive part 5, and a gap GP (interval) is provided between the adjacent first semiconductor parts S1. The first semiconductor part S1 may include an edge (side surface) E in the vicinity of the center of the growth suppressive part 5. As one example, a plurality of first semiconductor parts S1 each of which has a bar shape may be formed by causing the first semiconductor parts S1 to grow such that the adjacent first semiconductor parts S1 contact (meet) each other, and then removing the contacting portions thereof.

When the first semiconductor part S1 is formed by using the ELO method, the template substrate 7 may include a growth suppressive region (for example, a region in which crystal growth in the Z direction is suppressed) corresponding to the growth suppressive part 5, and a seed region corresponding to the opening portion K. For example, the growth suppressive region and the seed region may be formed above the main substrate 1, and the first semiconductor part S1 may be formed above the seed region and above the growth suppressive region by using the ELO method.

The laminate body LB includes the first semiconductor part S1 and the second semiconductor part S2 including the ridge portion RJ. According to the present embodiment, in the manufacturing method for the laser element, the second laminate body LB2 is formed in which the first growth suppressive part 5F and the second growth suppressive part 5S are aligned in the X direction (first direction). The second laminate body LB2 is adjacent to the first laminate body LB 1 in the first direction and includes the ridge portion RJ. In this specification, when the first laminate body LB 1 and the second laminate body LB2 are not distinguished from each other, the first laminate body LB1 and the second laminate body LB2 may be collectively referred to as a laminate body LB.

The first semiconductor part S1 and the second semiconductor part S2 may include a nitride semiconductor (for example, a GaN-based semiconductor). According to the present embodiment, the base semiconductor part 8 and the compound semiconductor part 9 in the laser body 21 described above are formed by cleaving the laminate body LB and thus dividing the first semiconductor part S1 and the second semiconductor part S2.

The first semiconductor part S1 may include a dislocation inheriting portion HD positioned on the opening portion K and a low-defect portion SD positioned on the growth suppressive part 5. In the first semiconductor part S1, the low-defect portion SD may have a threading dislocation density lower than that of the dislocation inheriting portion HD. The low-defect portion SD corresponds to the first portion B1 and the second portion B2 that have been described above, and the dislocation inheriting portion HD corresponds to the third portion B3 described above.

In this manner, even when the main substrate 1 included in the template substrate 7 is a heterogeneous substrate (a substrate having a lattice constant different from that of the first semiconductor part S1), the low-defect portion SD having a low threading dislocation density can be formed on the growth suppressive part 5. Cathode luminescence (CL) measurement on the surfaces (c-plane) of the first semiconductor part S1 and the second semiconductor part S2 or a cross section parallel to the surfaces enables observation of the threading dislocation.

Since the number of surface defects in the low-defect portion SD of the first semiconductor part S1 is small, a portion of the second semiconductor part S2 overlapping with the low-defect portion SD in plan view can reduce the number of dislocations (defects) inherited from the low-defect portion SD to the second semiconductor part S2. The optical resonator LK can be formed at this portion. In this case, the possibility that the performance of the optical resonator LK deteriorates due to the influence of the threading dislocation can be reduced, and thus light emission efficiency of the laser element can be improved.

According to the present embodiment, in the manufacturing method for the laser element, scribing is performed on the base substrate BK at a portion of the laminate body LB on the side where the ridge portion RJ is positioned. Thereby, the laminate body LB is cleaved without dividing the base substrate BK, and the laminate body LB is divided into a plurality of laser bodies 21. The laser body 21 includes a pair of resonator end surfaces F1 and F2 (see FIG. 1 and FIG. 2).

Scribing on the laminate body LB may be performed by applying a mechanical external force to the laminate body LB and may be performed by using, for example, a diamond scriber. A specific method of scribing is not particularly limited as long as the laminate body LB can be cleaved to form the resonator end surfaces F1 and F2. Scribing of the laminate body LB may be performed by locally applying heat to the laminate body LB, and may be performed by using, for example, a laser scriber.

In FIG. 7 and FIG. 8, an example in which the laminate body LB is scribed with a scribing tool 90 is illustrated, and a track of a tip of the scribing tool 90 is virtually illustrated by using a dashed line. The lowermost diagram in each of FIG. 7 and FIG. 8 illustrates a state after the second laminate body LB2 and the first laminate body LB1 are scribed. The lowermost diagram in FIG. 7 is a side view schematically illustrating an end surface of the laser body 21 after cleaving.

The present inventors have found that when the laminate body LB is cleaved by scribing the laminate body LB, the following phenomenon occurs. That is, when the cleaving of the first semiconductor part S1 and the second semiconductor part S2 that contain a nitride semiconductor proceeds in the X direction with a scribing position as a starting point (cleaving starting point), the cleaving passes through the dislocation inheriting portion HD in the first semiconductor part S1. As a result, at the end surface of the laser body 21, a damage portion DP having a flaw may occur in the dislocation inheriting portion HD, the low-defect portion SD on a side far from the scribing mark M, and a portion of the compound semiconductor part 9 above the dislocation inheriting portion HD and the low-defect portion SD. When the resonator end surfaces F1 and F2 of the optical resonator LK and the damage portion DP overlap each other, light emission efficiency of the optical resonator LK may decrease.

When the first semiconductor part S1 containing a nitride semiconductor is formed on a heterogeneous substrate such as a Si substrate by the ELO method, internal stress is generated in the first semiconductor part S1. When such a laminate body LB is scribed, internal stress in the first semiconductor part S1 is released and tensile strain is generated at the cleaving starting point. Thus, the cleaving spontaneously proceeds. In this case, the damage portion DP is more likely to be generated.

On the other hand, the damage portion DP caused by the influence of the dislocation inheriting portion HD is not generated in the portion of the end surface of the laser body 21 on the side where scribing is performed (the side with the scribing mark M serving as the cleaving starting point). Therefore, since the ridge portion RJ is positioned at the portion of the laser body 21 on the side where scribing is performed, the possibility that the light emission efficiency of the optical resonator LK is reduced due to the influence of properties of the resonator end surfaces F1 and F2 can be reduced.

Based on the above findings, according to the present embodiment, in another example of the manufacturing method for the laser element, scribing may be performed on the laminate body LB including the first semiconductor part S1 and the second semiconductor part S2 before forming the ridge portion RJ at the compound semiconductor part 9. In this case, the ridge portion RJ may be formed on the side where the scribing is performed.

The scribing of the laminate body LB may be performed on the second semiconductor part S2 or the first semiconductor part S1 as long as the laminate body LB can be cleaved. A shape of the track of the scribing tool 90 is not particularly limited, but an operation of the scribing tool 90 may be set according to a size of the gap GP formed between the plurality of first semiconductor parts S1. Depending on the position of the ridge portion RJ, a protruding portion for scribing the laminate body LB without damaging the ridge portion RJ may be formed. Various embodiments of the present disclosure will be described in detail by using the following examples.

### Example 1

An example of the present disclosure will be described in detail below. In the following description, in order to facilitate understanding of a manufacturing method for a laser element according to Example 1, first, a configuration of a laser body included in the laser element according to Example 1 and a configuration of the laser element in which the laser body is mounted on a support body will be described.

### Laser Body

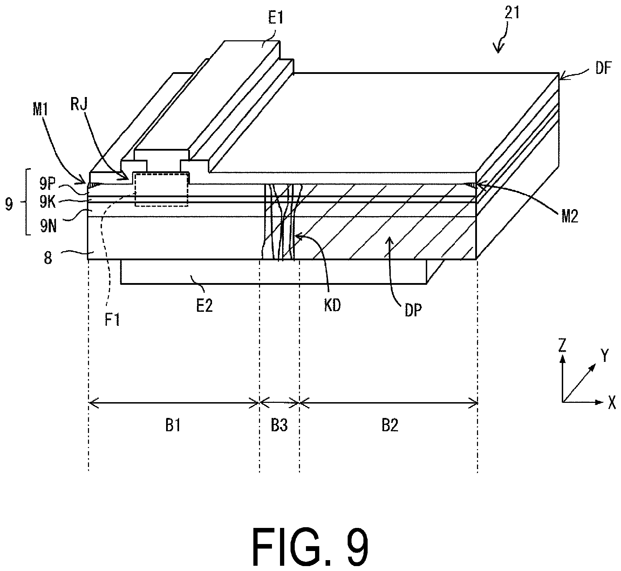

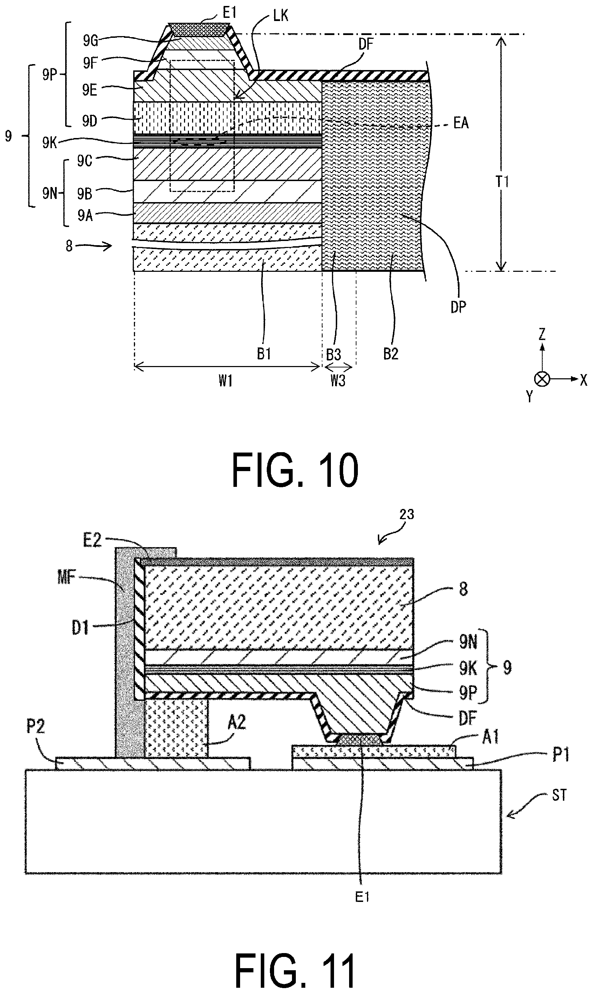

FIG. 9 is a perspective view illustrating the configuration of the laser body according to Example 1. FIG. 10 is a cross-sectional view illustrating the configuration of the laser body according to Example 1. FIG. 9 and FIG. 10 are also referred to as appropriate in the description of the manufacturing method for the laser element, which will be described later.

As illustrated in FIG. 9 and FIG. 10, according to Example 1, the laser body 21 includes the base semiconductor part 8, the compound semiconductor part 9 positioned on the base semiconductor part 8 and including the optical resonator LK including the active section 9K, the first electrode E1 serving as an anode, and the second electrode E2 as a cathode. The laser body 21 may also be referred to as a semiconductor laser chip.

The base semiconductor part 8 and the compound semiconductor part 9 may be nitride semiconductor layers (for example, GaN-based semiconductor layers), and the base semiconductor part 8 may be an n-type semiconductor layer including a donor. In FIG. 9 and the like, the X direction is the <11-20> direction (a-axis direction) of a nitride semiconductor crystal (wurtzite structure), the Y direction is the <1-100> direction (m-axis direction) of the nitride semiconductor crystal, and the Z direction is the <0001> direction (c-axis direction) of the nitride semiconductor crystal.

The base semiconductor part 8 includes the third portion B3 including a threading dislocation KD extending in the thickness direction (Z direction), and the first portion B1 and the second portion B2, each of which has a density of threading dislocations KD (threading dislocation density) lower than that of the third portion B3. The first portion B1, the third portion B3, and the second portion B2 are aligned in this order in the X direction, and the third portion B3 is positioned between the first portion B1 and the second portion B2. The third portion B3 is a portion, which will be described later, positioned above the opening portion K of the growth control pattern 6 (for example, a mask pattern) when the first semiconductor part S1 is formed by the ELO method.

The compound semiconductor part 9 is formed by forming, in this order, an n-type semiconductor part 9N including a donor, an active section 9K, and a p-type semiconductor part 9P including an acceptor. The n-type semiconductor part 9N includes a first contact portion 9A, a first cladding portion 9B, and a first optical guiding portion 9C, which are formed in this order. The p-type semiconductor part 9P includes a second optical guiding portion 9D, an electron blocking portion 9E, a second cladding portion 9F, and a second contact portion 9G, which are formed in this order. The first electrode E1 (anode) is formed on the second contact portion 9G. Each of the active section 9K, each part included in the n-type semiconductor part 9N, and each part included in the p-type semiconductor part 9P may have a layer shape (for example, the active section 9K may be an active layer). Note that in the p-type semiconductor part 9P of the compound semiconductor part 9, the second optical guiding portion 9D and the electron blocking portion 9E may be exchanged with each other. For example, the p-type semiconductor part 9P may include the electron blocking portion 9E, the second optical guiding portion 9D, the second cladding portion 9F, and the second contact portion 9G, which are formed in this order.

In Example 1, the second electrode E2 is provided on a side (a back surface of the base semiconductor part 8) different from the first electrode E1 with respect to the first semiconductor part S1, and the first electrode E1 and second electrode E2 overlap each other in plan view.

The compound semiconductor part 9 includes the optical resonator LK including the pair of resonator end surfaces F1 and F2. A resonator length L1 that is a distance between the pair of resonator end surfaces F1 and F2 may be 200 [µm] or less, 150 [µm] or less, or 100 [µm] or less. A lower limit of the resonator length L1 is not particularly limited as long as the optical resonator LK can function, and may be 50 [µm], for example. The base semiconductor part 8 and the compound semiconductor part 9 may contain a GaN-based semiconductor. The compound semiconductor part 9 includes the resonator end surfaces F1 and F2 that are the m-plane of a GaN-based semiconductor crystal.

Each of the resonator end surfaces F1 and F2 is covered with the reflector film UF (for example, a dielectric film), and an optical reflectance of the resonator end surface F1 on a light emission surface side is 98% or more. An optical reflectance of the resonator end surface F2 on a light reflection surface side is higher than the optical reflectance of the resonator end surface F 1. Although not illustrated in FIG. 9 and FIG. 10, the reflector film UF can be formed over the entire cleaved surface (m-plane) of the base semiconductor part 8 and the compound semiconductor part 9.

The first electrode E1 overlaps the optical resonator LK in plan view and overlaps the first portion B1 of the base semiconductor part 8. The first electrode E1 has a shape having a resonator length direction (Y direction) as a longitudinal direction. The length of the first electrode E1 in the Y direction may be smaller than the resonator length L1. In this case, when the laminate body LB is cleaved, the first electrode E1 does not interfere with the cleaving.

The optical resonator LK includes a part of the n-type semiconductor part 9N, a part of the active section 9K, and a part of the p-type semiconductor part 9P (portions overlapping the first electrode E1 in plan view). For example, the optical resonator LK includes a part of the first cladding portion 9B, a part of the first optical guiding portion 9C, a part of the active section 9K, a part of the second optical guiding portion 9D, a part of the electron blocking portion 9E, and a part of the second cladding portion 9F (portions overlapping the first electrode E1 in plan view).

In the optical resonator LK, indices of refraction (indices of optical refraction) decrease in the order of the active section 9K, the first optical guiding portion 9C, and the first cladding portion 9B, and indices of refraction decrease in the order of the active section 9K, the second optical guiding portion 9D, and the second cladding portion 9F. Thus, light generated by coupling of holes supplied from the first electrode E1 and electrons supplied from the second electrode E2 in the active section 9K is confined in the optical resonator LK (in particular, in the active section 9K), and laser oscillation occurs due to stimulated emission and feedback action in the active section 9K. The laser light generated by the laser oscillation is emitted from a light emission region EA of the resonator end surface F1 on the emission surface side.

Since the resonator end surfaces F1 and F2 are formed by m-plane cleavage, the resonator end surfaces F1 and F2 are excellent in planarity and verticality to the c-plane (parallelism of the resonator end surfaces F1 and F2) and have a high optical reflectance. Thus, return loss can be reduced, and stable laser oscillation is possible even at short resonance lengths of 200 µm or less where an optical gain is small. Since the resonator end surfaces F1 and F2 are formed above the first portion B1 that is the low-defect portion SD, the planarity of the cleaved surface is excellent, and a high optical reflectance is achieved.

The compound semiconductor part 9 includes the ridge portion RJ positioned above the first portion B1 and overlapping the first electrode E1 in plan view. The ridge portion RJ may include the second cladding portion 9F and the second contact portion 9G. The laser body 21 includes the scribing mark M1 corresponding to the cleaving starting point and generated by scribing a portion on the side where the ridge portion RJ is positioned in the X direction. The laser body 21 may include the scribing mark M1 at the compound semiconductor part 9. The laser body 21 may include the damage portion DP at the end surface, and may include a secondary scribing mark M2 at a portion on the side opposite to the side where the ridge portion RJ is positioned in the X direction. The secondary scribing mark M2 will be described later together with the description of the manufacturing method for the laser element.

The ridge portion RJ is shaped with the Y direction as the longitudinal direction, and the insulating film DF is provided so as to cover a side surface of the ridge portion RJ. The insulating film DF may cover an upper surface of the p-type semiconductor part 9P except for a contact portion between the first electrode E1 and the ridge portion RJ. Both end portions in the X direction of the first electrode E1 may overlap the insulating film DF in plan view. An index of refraction of the insulating film DF is smaller than the indices of refraction of the second optical guiding portion 9D and the second cladding portion 9F. By providing the ridge portion RJ and the insulating film DF, a current path between the first electrode E1 and the base semiconductor part 8 is narrowed on the anode side, and light can be efficiently emitted in the resonator LK.

The ridge portion RJ overlaps the first portion B1 (low-defect portion) of the base semiconductor part 8 in plan view and does not overlap the third portion B3. In this manner, a current path from the first electrode E1 to the second electrode E2 through the compound semiconductor part 9 and the base semiconductor part 8 is formed in a portion overlapping the first portion B1 in plan view (a portion having few threading dislocations), and light emission efficiency in the active section 9K is enhanced. This is because the threading dislocations act as a non-light-emission recombination center. Since the second electrode E2 overlaps the third portion B3 (low-dislocation part) of the base semiconductor part 8 in plan view, efficiency of electron injection from the second electrode E2 to the base semiconductor part 8 is enhanced.

In Example 1, a sum T1 of a thickness of the base semiconductor part 8 and a thickness of the compound semiconductor part 9 can be set to a value of 50 [µm] or less. If the sum T1 of the thicknesses is too large, it becomes difficult to perform cleaving such that the resonator length L1 becomes 200 µm or less. A ratio of the resonator length L1 to the thickness of the first portion B1 of the base semiconductor part 8 can be set to a value from 1 to 20. When a direction orthogonal to the direction of the resonator length L1 is defined as a first direction (X direction) and a size of the first portion B1 in the X direction is defined as a width W1 of the first portion B1, a ratio of the resonator length L1 to the width W1 of the first portion B1 can be set to a value from 1 to 10. When a size of the third portion B3 in the X direction is defined as a width W3 of the third portion B3, a ratio of the resonator length L1 to the width W3 of the third portion B3 can be set to a value from 1 to 200.

### Laser Element

FIG. 11 is a cross-sectional view illustrating a configuration of the laser element in Example 1. A laser element (semiconductor laser element) 23 includes the laser body 21 including the base semiconductor part 8 and the compound semiconductor part 9, and a support body ST holding the laser body 21. Examples of a material of the support body ST include Si, SiC, and AlN. The second electrode E2 is positioned on the back surface of the base semiconductor part 8, and the compound semiconductor part 9 and the first electrode E1 are closer to the support body ST than the base semiconductor part 8 (junction-down manner).

The support body ST (for example, submount) includes a first pad portion P1 and a second pad portion P2 that have electrical conductivity, and the first electrode E1 is connected to a first pad portion P1 with a first bonding portion A1 interposed therebetween. In the laser element 23, an insulating film D1 and an electrically conductive film MF may be formed so as to cover the side surfaces of the first semiconductor part S1 and the second semiconductor part S2 on a side farther from the ridge portion RJ. The electrically conductive film MF electrically connects the second electrode E2 and the second bonding portion A2 or the second pad portion P2. There is no limitation regarding a material used for the electrically conductive film MF. The electrically conductive film MF may be in contact with the insulating film D1 and/or the second bonding portion A2. The second electrode E2 is connected to the second pad portion P2 through the electrically conductive film MF.

The insulating film DF and the second pad portion P2 may be bonded to each other with the second bonding portion A2 interposed therebetween. In this case, stability when the support body ST supports the laser body 21 can be improved.

The second bonding portion A2 is thicker than the first bonding portion A1. This enables the first electrode E1 and second electrode E2 to be connected to the first pad portion P1 and second pad portion P2 positioned on the same plane. The laser element 23 functions as a chip on submount (COS).

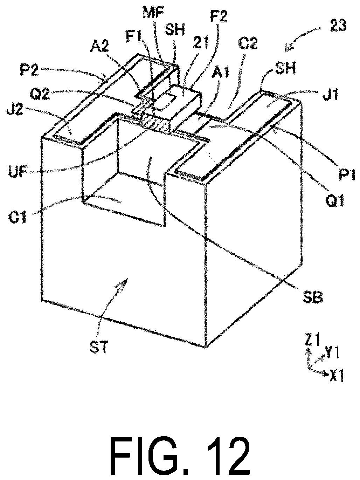

An example of the support body ST in the laser element 23 will be described below with reference to FIG. 12. FIG. 12 is a perspective view illustrating the configuration of the laser element according to Example 1. FIG. 12 illustrates X1Y1Z1 axes for the support body ST. A positive direction of the Z axis in the X1Y1Z1 axes illustrated in FIG. 12 is inverted compared with the XYZ axes illustrated in FIG. 1 and the like.

As illustrated in FIG. 12, the laser element 23 includes the laser body 21 and the support body ST. The support body ST includes two wide portions SH each of which has a width larger than the resonator length L 1 of the laser body 21 and a placement portion SB positioned between the two wide portions SH and having a width smaller than the resonator length L1. The laser body 21 is positioned above the placement portion SB such that a width direction (Y1 direction) of the placement portion SB coincides with a direction of the resonator length L 1, and the pair of resonator end surfaces F1 and F2 protrude from the placement portion SB in plan view. In other words, the placement portion SB is formed between two notches C1 and C2 facing each other in the direction (Y1 direction) defining the resonator length L1, the resonator end surface F1 is positioned above the notch C1, and the resonator end surface F2 is positioned above the notch C2. Shapes of the notches C1 and C2 can be, for example, rectangular in plan view in the Z1 direction. By providing the support body ST with the notches C1 and C2 and disposing the resonator end surface F1 so as to protrude from the placement portion SB, an optical path of laser light emitted from the resonator end surface F1 does not overlap the support body ST having a light shading property.

The support body ST includes the first pad portion P1 and the second pad portion P2 having T shapes. The first pad portion P1 includes a mounting part J1 positioned on the wide portion SH and having a length in the Y1 direction larger than the resonator length L1, and a contact portion Q1 positioned on the placement portion SB and having a length in the Y1 direction smaller than the resonator length L1. The second pad portion P2 includes a mounting part J2 positioned on the wide portion SH and having a length in the Y1 direction larger than the resonator length L1, and a contact portion Q2 positioned on the placement portion SB and having a length in the Y1 direction smaller than the resonator length L1. The contact portions Q1 and Q2 are aligned in the X1 direction on an upper surface of the placement portion SB, the first bonding portion A1 is formed on the contact portion Q1, and the second bonding portion A2 is formed on the contact portion Q2. The first bonding portion A1 is in contact with the first electrode E1 of the laser body 21. The second electrode E2 of the laser body 21 is in contact with the second bonding portion A2 or the contact portion Q2 through the electrically conductive film MF. A solder such as AuSi or AuSn can be used as materials of the first bonding portion A1 and second bonding portion A2.

### Manufacturing Method for Laser Element

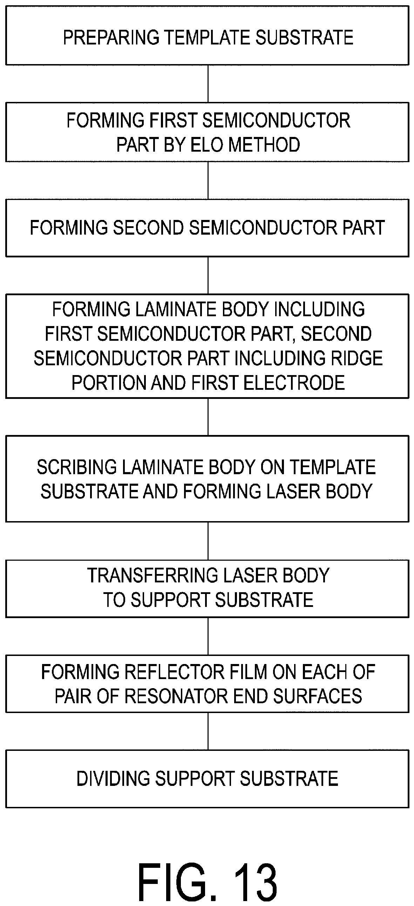

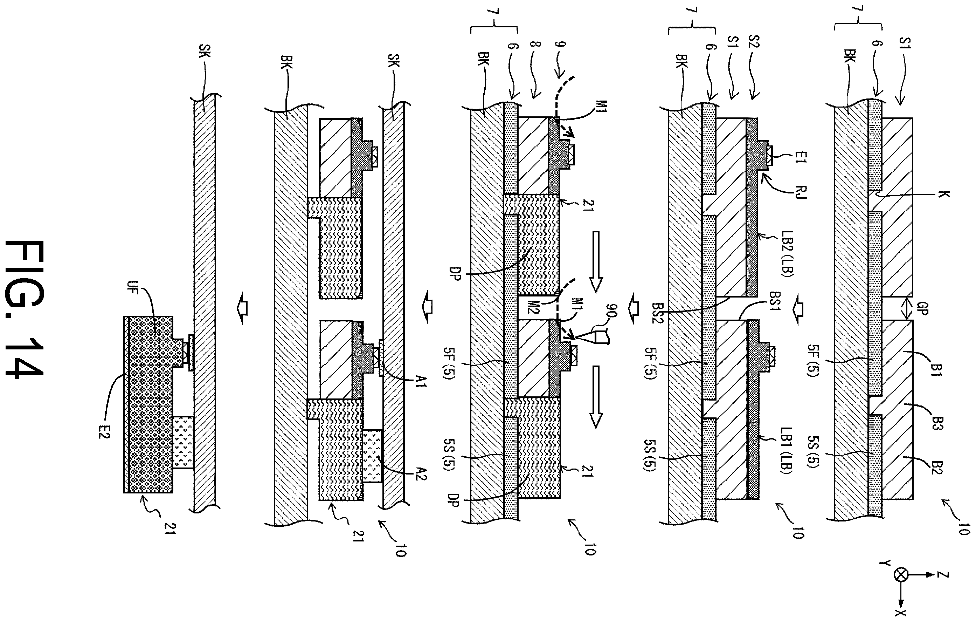

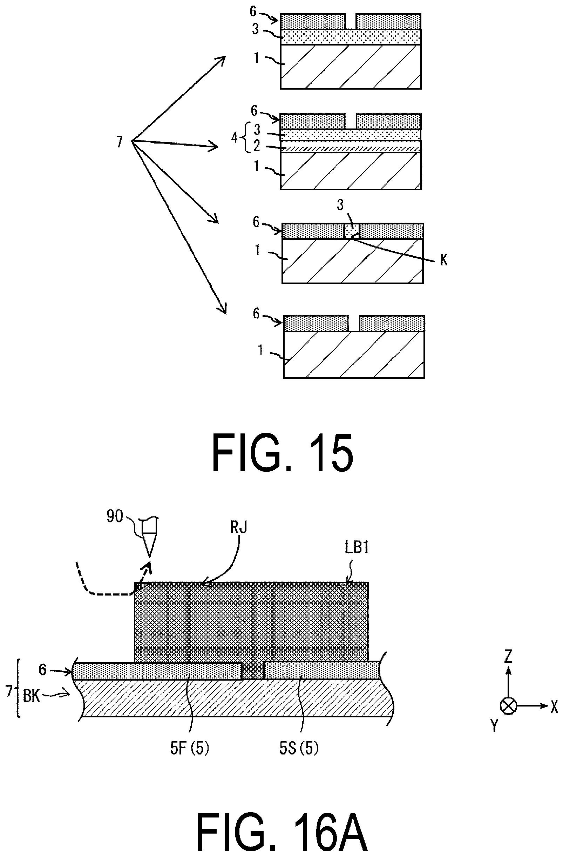

FIG. 13 is a flowchart schematically illustrating the manufacturing method for the laser element according to Example 1. FIG. 14 is a cross-sectional view schematically illustrating the manufacturing method for the laser element according to Example 1. FIG. 15 is a cross-sectional view illustrating a configuration example of a template substrate. In FIG. 14, the thickness of the second semiconductor part S2, the ridge portion RJ, and the like are exaggerated.

### Template Substrate

In the manufacturing method for the laser element according to Example 1, as illustrated in FIG. 13 and FIG. 14, first, the template substrate 7 is prepared. The template substrate 7 includes the base substrate BK and the growth control pattern 6 (for example, a mask pattern) positioned above the base substrate BK.

As illustrated in FIG. 15, the template substrate 7 may have a configuration in which the seed portion 3 and the growth control pattern 6 (for example, a mask pattern) are formed in this order on the main substrate 1, or may have a configuration in which a plurality of underlying portions 4 (including a buffer portion 2 and a seed portion 3) and the growth control pattern 6 (for example, a mask pattern) are formed in this order on the main substrate 1. The seed portion 3 may be locally formed (for example, in a stripe shape) so as to overlap the opening portion K of the growth control pattern 6 (for example, a mask pattern) in plan view. The seed portion 3 may contain a nitride semiconductor formed at a low temperature of 600°C or less. This can reduce warp of the semiconductor substrate 10 (the template substrate 7 and the first semiconductor part S1) caused by stress of the seed portion 3. The seed portion 3 can be film-formed by using a sputtering apparatus (PSD: pulse sputter deposition, PLD: pulse laser deposition, or the like). The use of the sputtering apparatus has advantages in that low-temperature film formation and large-area film formation are possible, the cost is reduced, and the like. As illustrated in FIG. 15, the template substrate 7 may be formed with the growth control pattern 6 (for example, a mask pattern) on the main substrate 1 (for example, a SiC bulk crystal substrate or a GaN bulk crystal substrate).

As described above, the base substrate BK may include at least the main substrate 1. A heterogeneous substrate having a lattice constant different from that of a GaN-based semiconductor may be used for the main substrate 1. Examples of the heterogeneous substrate include a single crystal silicon (Si) substrate, a sapphire (Al₂O₃) substrate, and a silicon carbide (SiC) substrate. The plane orientation of the main substrate 1 is, for example, the (111) plane of the silicon substrate, the (0001) plane of the sapphire substrate, or the 6H-SiC (0001) plane of the SiC substrate. These are merely examples, and any main substrate and any plane orientation may be used as long as the first semiconductor part S1 can be grown by the ELO method. A SiC (bulk crystal) substrate, a GaN (bulk crystal) substrate, or an AlN (bulk crystal) substrate can be used as the main substrate 1.

The buffer portion 2 and the seed portion 3 may be provided in this order from the main substrate 1 side, as the underlying portion 4 illustrated in FIG. 15. For example, when a silicon substrate is used for the main substrate 1 and a GaN-based semiconductor is used for the seed portion 3, these (the main substrate and the seed portion) melt together, and thus the possibility that the main substrate 1 and the seed portion 3 melt together is reduced by providing the buffer portion 2 including an AlN layer and/or a silicon carbide (SiC) layer. The buffer portion 2 may have an effect of enhancing crystallinity of the seed portion 3 and/or an effect of alleviating internal stress of the first semiconductor part S1. When the main substrate 1 that is unlikely to melt with the seed portion 3 is used, a configuration is applicable in which the buffer portion 2 is not provided. Note that the configuration in which the seed portion 3 overlaps the entire growth suppressive part 5 as illustrated in FIG. 15 is not necessarily employed. Since the seed portion 3 is exposed through the opening portion K, the seed portion 3 may be locally formed so as not to overlap a part or the entirety of the growth suppressive part 5.

In the template substrate in which the growth control pattern 6 is the mask pattern and the growth suppressive part 5 is the mask portion, the opening portion K functions as a growth start hole through which the seed portion 3 is exposed and the growth of the first semiconductor part S1 is started. The mask portion functions as a selective growth mask for lateral growth of the first semiconductor part S1.

Examples of the growth suppressive part 5 (mask portion) that can be used include a single layer film including any one of a silicon oxide film (SiOx), a titanium nitride film (TiN or the like), a silicon nitride film (SiNx), a silicon oxynitride film (SiON), and a metal film having a high melting point (for example, 1000°C or higher), or a layered film including at least two thereof.

For example, a silicon oxide film having a thickness of from about 100 nm to about 4 µm (preferably from about 150 nm to about 2 µm) is formed on the entire surface of the seed portion 3 by using sputtering, and a resist is applied onto the entire surface of the silicon oxide film. Subsequently, the resist is patterned by photolithography to form the resist with a plurality of opening portions having a stripe shape. Subsequently, a part of the silicon oxide film is removed with a wet etchant such as a hydrofluoric acid (HF) or a buffered hydrofluoric acid (BHF) to form the plurality of opening portions K, and the resist is removed by organic cleaning. Thus, the growth suppressive part 5 (mask portion) is formed. As another example, the silicon nitride film may be formed by using a sputtering apparatus, a plasma enhanced chemical vapor deposition (PECVD) device, or the like. Even if the silicon nitride film is thinner than the silicon oxide film, the silicon nitride film can withstand the film formation temperature (about 1000°C) of the base semiconductor part 8. The thickness of the silicon nitride film can be set to from about 5 nm to about 4 µm.

The opening portions K each of which has the longitudinal shape (slit shape) can be periodically arrayed in the X direction. The width of the opening portion K may be set to from about 0.1 µm to about 20 µm. The smaller the width of the opening portion K, the smaller the number of threading dislocations propagating from the opening portion K to the first semiconductor part S1. As the width of the opening portion K is smaller, the widths (sizes in the X direction) of the first portion B1 and the second portion B2 (low-defect portion SD) can be increased.

The silicon oxide film may be decomposed and evaporated in a small amount during film formation of the first semiconductor part S1 and may be taken into the first semiconductor part S1, but the silicon nitride film and the silicon oxynitride film have an advantage in terms of hardly decomposing and evaporating at a high temperature. The growth suppressive part 5 (mask portion) may be a single layer film of a silicon nitride film or a silicon oxynitride film. The growth suppressive part 5 (mask portion) may be a layered film in which a silicon oxide film and a silicon nitride film are formed in this order on the seed portion 3. The growth suppressive part 5 (mask portion) may be a layered film in which a silicon nitride film and a silicon oxide film are formed in this order on the seed portion 3. The growth suppressive part 5 (mask portion) may be a layered film in which a silicon nitride film, a silicon oxide film, and a silicon nitride film are formed in this order on the underlying portion 4. A desired oxynitride film may be formed by controlling compositions of oxygen and nitrogen of SiON.

An abnormal portion such as a pinhole in the growth suppressive part 5 (mask portion) may be eliminated by performing organic cleaning or the like after film formation, introducing the film again into a film forming device, and thus forming the same type of film. The growth suppressive part 5 (mask portion) having a high quality can be formed by using a general silicon oxide film (single layer) and using the above-described film re-formation method.

In Example 1, as an example of the template substrate 7, a silicon substrate having a (111) plane (for example, Si substrate of 2 inches) may be used for the main substrate 1, an AlN layer (from about 30 nm to about 300 nm, for example, 150 nm) may be used for the buffer portion 2, a GaN-based graded layer may be used for the seed portion 3, and a laminate mask in which a silicon oxide film (SiO₂) and a silicon nitride film (SiN) are formed in this order may be used for the growth suppressive part 5 (mask portion). The GaN-based graded layer may include an Al_{0.6}Ga_{0.4}N layer (for example, 300 nm) that is a first layer and a GaN layer (for example, from 1 µm to 2 µm) that is a second layer. As for the growth suppressive part 5 (mask portion), by using a CVD method (plasma chemical vapor deposition method) for film formation of each of the silicon oxide film and the silicon nitride film, a thickness of the silicon oxide film can be set to, for example, 0.3 µm and a thickness of the silicon nitride film can be set to, for example, 70 nm. The width (size in the X direction) of the growth suppressive part 5 can be set to 50 µm, and the width (size in the X direction) of the opening portion K can be set to 5 µm.

### First Semiconductor Part

The first semiconductor part S1 is formed on the template substrate 7 by using the ELO method. In Example 1, a GaN layer was used for the first semiconductor part S1, and an ELO film formation of gallium nitride (GaN) was performed on the above-described template substrate 7 by using a metal-organic chemical vapor deposition (MOCVD) apparatus. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount).

In this case, the first semiconductor part S1 was selectively grown (vertically grown) on the seed portion 3 exposed from the opening portion K and was subsequently laterally grown on the growth suppressive part 5. The lateral growth was stopped before GaN crystal films laterally grown from both sides on the growth suppressive part 5 met each other. In Example 1, the plurality of first semiconductor parts S1 are formed by stopping the growth before semiconductor crystals (for example, GaN-based crystals) growing so as to approach each other on the growth suppressive part 5 meet each other. Thus, a gap GP is formed between the first semiconductor parts S1 adjacent to each other in the X direction. The X direction may be the <11-20> direction (a-axis direction) of the GaN-based crystal, the Y direction may be the <1-100> direction (m-axis direction) of the GaN-based crystal, and the Z direction may be the <0001> direction (c-axis direction) of the GaN-based crystal.

In the formation of the first semiconductor part S1 in Example 1, a vertical growth layer that grows in the Z direction (c-axis direction) is formed on the seed portion 3 exposed from the opening portion K, and then a lateral growth layer that grows in the X direction (a-axis direction) is formed. In this case, when the thickness of the vertical growth layer is set to 10 µm or thinner, 5 µm or thinner, or 3 µm or thinner, a thickness of the lateral growth layer can be reduced, increasing a lateral film formation rate.

A threading dislocation density of the low-defect portion SD (the first portion B1 or the second portion B2) may be one fifth or less (for example, 5 × 10⁶/cm² or less) of a threading dislocation density of the dislocation inheriting portion HD (third portion B3). The threading dislocation density here can be obtained by, for example, performing CL measurement (for example, counting the number of black spots) on the surface of the first semiconductor part S1. The dislocation density can be expressed in units of [quantity/cm²], and, in this specification, may be expressed as [/cm²] with the quantity omitted. A basal plane dislocation density of the low-defect portion SD (the first portion B1 or the second portion B2) may be 5 × 10⁸/cm² or less. The basal plane dislocation may be a dislocation extending in an in-plane direction of the c-plane (X-Y plane) of the first semiconductor part S1. The basal plane dislocation density here can be obtained by, for example, dividing the first semiconductor part S1 to expose a side surface of the low-defect portion SD and performing the CL measurement of a dislocation density of the side surface.

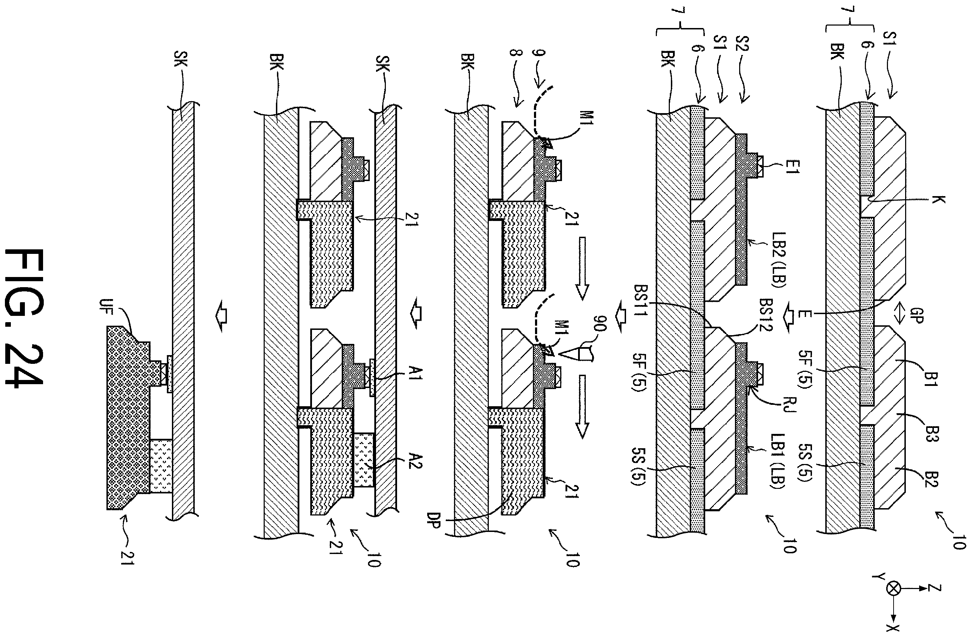

A lateral width (size in the X direction) of the first semiconductor part S1 was 53 µm, a width (size in the X direction) of the first portion B1 (or the second portion B2) as the low-defect portion SD was 24 µm, and a layer thickness (size in the Z direction) of the first semiconductor part S1 was 5 µm. An aspect ratio of the first semiconductor part S1 was 53 µm/5 µm = 10.6, and a very high aspect ratio was achieved. The width of the growth suppressive part 5 can be set in accordance with specifications of the compound semiconductor part 9 and the like (for example, from about 10 µm to about 200 µm). In Example 1, the first semiconductor parts S1 adjacent to each other do not meet each other, and a plurality of first semiconductor parts S1 each of which has a bar shape are formed side by side in the X direction on the template substrate 7. The lateral width (size in the X direction) of the gap GP may vary under the influence of inclination of the side surface, which will be described later (see FIG. 24), and was, for example, about 5 µm.

As described above, in Example 1, the semiconductor substrate 10 including the base substrate BK, the first growth suppressive part 5F and the second growth suppressive part 5S adjacent to each other with the opening portion K interposed therebetween, and the first semiconductor part S1 having a longitudinal shape and positioned on the first growth suppressive part 5F and the second growth suppressive part 5S from the opening portion K is prepared. The first semiconductor part S1 may contain a GaN-based semiconductor, and the first growth suppressive part 5F and the second growth suppressive part 5S may be aligned in the X direction (<11-20> direction of the GaN-based semiconductor).

### Second Semiconductor Part

The second semiconductor part S2 can be formed by the MOCVD method, for example. For example, an n-type GaN layer can be used for the first contact portion 9A, for example, an n-type AlGaN layer can be used for the first cladding portion 9B, for example, an n-type GaN layer can be used for the first optical guiding portion 9C, for example, a multi-quantum well (MQW) structure including an InGaN layer can be used for the active section 9K, for example, a p-type AlGaN layer can be used for an electron blocking portion 9E, for example, a p-type GaN layer can be used for the second optical guiding portion 9D, for example, a p-type AlGaN layer can be used for the second cladding portion 9F, and a p-type GaN layer can be used for the second contact portion 9G.

A regrowth part (for example, the buffer layer containing an n-type GaN-based semiconductor) may be formed on the first semiconductor part S1, and the second semiconductor part S2 may be formed on the regrowth part. The n-type semiconductor part 9N may be formed of the regrowth part, and the active section 9K and the p-type semiconductor part 9P may be formed as the second semiconductor part S2 on the regrowth part. The regrowth part can be formed by using, for example, an MOCVD method.

The thicknesses of the layers of the laser body 21 can be set as follows: the first semiconductor part S1 > the first cladding portion 9B > the first optical guiding portion 9C > the active section 9K, and the first semiconductor part S1 > the second cladding portion 9F > the second optical guiding portion 9D > the active section 9K.

### Laminate Body

According to Example 1, in the manufacturing method for the laser element, next, a ridge stripe structure, that is, the ridge portion RJ is formed by photolithography, and then the insulating film DF is formed (the insulating film DF is not illustrated in FIG. 14). The first electrode E1 is formed on the second contact portion 9G of the ridge portion RJ. As a result, the semiconductor substrate 10 including a plurality of laminate bodies LB each of which has a bar shape can be formed. The ridge portion RJ is positioned on the upper layer side relative to the active section 9K. The ridge portion RJ may have a ridge shape extending in the longitudinal direction of the first semiconductor part S1.

For the first electrode E1 (anode), for example, a single layer film or a multilayer film including a metal film, which may be an alloy film, containing at least one selected from the group consisting of Ni, Rh, Pd, Cr, Au, W, Pt, Ti, and Al and/or an electrically conductive oxide film containing at least one selected from the group consisting of Zn, In, and Sn can be used. For the insulating film DF covering the ridge portion RJ, a single layer film or a layered film containing an oxide or nitride of, for example, Si, Al, Zr, Ti, Nb, or Ta can be used.

The first electrode E1 may include a p-contact electrode and a p-pad electrode. The p-contact electrode may be, for example, a Pd film having a thickness of 50 nm. The p-pad electrode may be a multilayer film in which, for example, a Ti film having a thickness of 100 nm, a Ni film having a thickness of 200 nm, and an Au film having a thickness of 100 nm are formed in this order.

The index of refraction of the insulating film DF is smaller than the indices of refraction of the second optical guiding portion 9D and the second cladding portion 9F. Providing the ridge portion RJ and the insulating film DF narrows a current path between the first electrode E1 and the first semiconductor part S1 on the anode side, allowing light to be efficiently emitted in the resonator LK.

### Laser Body

According to Example 1, next, in the manufacturing method for the laser element, the laminate body LB is scribed on the template substrate 7. Thereafter, cleavage of the laminate body LB is performed (m-plane cleavage of the first semiconductor part S1 and second semiconductor part S2, which are nitride semiconductor layers) to form the laser body 21 including the pair of resonator end surfaces F1 and F2.

When the laminate body LB has a bar shape, the laminate body LB is cleaved in the direction (X direction) orthogonal to the longitudinal direction (Y direction) of the laminate body LB. The end surfaces produced by the cleavage can be used as the resonator end surfaces F1 and F2, and a plurality of pieces obtained by dividing the laminate body LB can be used as the laser bodies 21.

A plurality of first electrodes E1 aligned in the longitudinal direction (Y direction) of the first semiconductor part S1 may be formed on the ridge portion RJ before the scribing, and a cleaved surface generated by the scribing does not need to intersect with the first electrode E1.

In Example 1, the laminate body LB is scribed by a diamond scriber. The scribing tool 90 in the diamond scriber has, for example, a needle shape, and a portion that comes into contact with a scribing target is made of diamond.

The third diagram from the top in FIG. 14 illustrates a state after the second laminate body LB2 and the first laminate body LB1 are scribed. The third and subsequent diagrams from the top in FIG. 14 are side views illustrating the end surface of the laser body 21 formed by cleaving the laminate body LB.

In Example 1, the cleavage of the first laminate body LB1 may spontaneously proceed when the laminate body LB1 is scribed. The first laminate body LB1 is cleaved on the base substrate BK without dividing the base substrate BK. In general, after the cleaving starting point is formed by performing scribing, stress may be applied to cause cleavage from the cleaving starting point in some cases. However, in Example 1, the cleavage of the laminate body LB can spontaneously proceed. "Cleavage proceeds spontaneously when scribing is performed" means that scribing and cleavage occur at the same or substantially the same timing (cleavage occurs spontaneously with scribing).

The first semiconductor part S1 contains a GaN-based semiconductor, and the base substrate BK includes the main substrate 1 (for example, a Si substrate) made of a material having a thermal expansion coefficient smaller than that of the GaN-based semiconductor.

When the first semiconductor part S1 is formed on a heterogeneous substrate such as a Si substrate by the ELO method, a film-forming temperature is a high temperature of 1000°C or more. Decreasing the temperature to a room temperature, after the film forming, causes the occurrence of internal stress in the first semiconductor part S1. The internal stress is caused by a difference in thermal expansion coefficient between the main substrate 1 and the first semiconductor part S1.

When the thermal expansion coefficient of the main substrate 1 is smaller than that of the first semiconductor part S1, tensile stress occurs in the first semiconductor part S1. For example, when the main substrate 1 is a Si substrate and the constituent material of the first semiconductor part S1 is GaN, tensile stress occurs in the first semiconductor part S1. Due to the difference in lattice constant between the main substrate 1 and the base semiconductor part 8, strain occurs at the first semiconductor part S1, which causes the occurrence of internal stress in the first semiconductor part S1 in some cases. When such a laminate body LB is scribed, the internal stress in the first semiconductor part S1 is released and tensile strain is generated at the cleaving starting point. Thus, cleavage spontaneously proceeds.

In Example 1, the scribing tool 90 may be inserted from the side surface BS1 closer to the ridge portion RJ among the two side surfaces along the longitudinal direction of the first laminate body LB1. The scribing may be performed such that the scribing tool 90 is taken out from the upper surface of the first laminate body LB1. A position at which the scribing tool 90 protrudes from the upper surface of the first laminate body LB1 may be on an outer side relative to the ridge portion RJ. The position at which the scribing tool 90 protrudes from the upper surface of the first laminate body LB1 may be at a distance of 3 [µm] or less from the side surface BS1 closer to the ridge portion RJ. Accordingly, the possibility that the scribing tool 90 comes into contact with the ridge portion RJ and the ridge portion RJ is damaged can be reduced.

The second semiconductor part S2 contains a nitride semiconductor, and the direction of a force applied to the second semiconductor part S2 with the scribing tool 90 can be parallel to the m-plane of the second semiconductor part S2 (the m-plane of the nitride semiconductor crystal in the second semiconductor part S2).

In Example 1, with the scribing tool 90, the second laminate body LB2 is scribed and then the first laminate body LB1 is scribed. The damage portion DP is formed on the end surface of the laser body 21 formed by cleaving the first laminate body LB 1 and the laminate body LB2. In the damage portion DP, the second portion B2 may have, for example, a linear scratch extending from the third portion B3 (see FIG. 10).

The second laminate body LB2 may be formed at a distance of 5 [µm] or more from the first laminate body LB1. For example, the first semiconductor part S1 may formed having the gap GP of 5 [µm] or more. When an interval between the second laminate body LB2 and the first laminate body LB 1 is narrow, even if the track of the scribing tool 90 is attempted to contact only the first laminate body LB 1 without contacting the second laminate body LB2, the scribing tool 90 may inevitably contact the second laminate body LB2 depending on the capability of the scriber. The track of the scribing tool 90 may be set such that in scribing the first laminate body LB1, the scribing tool 90 comes into contact with the damage portion DP of the cleaved surface formed by cleaving the second laminate body LB2. In this case, the scribing mark M1 is formed at the laser body 21 formed by cleaving the first laminate body LB 1, and the secondary scribing mark M2 is formed at the laser body 21 formed by cleaving the second laminate body LB2. This allows the optical resonator LK of the laser body 21 formed by cleaving the second laminate body LB2 not to be affected.

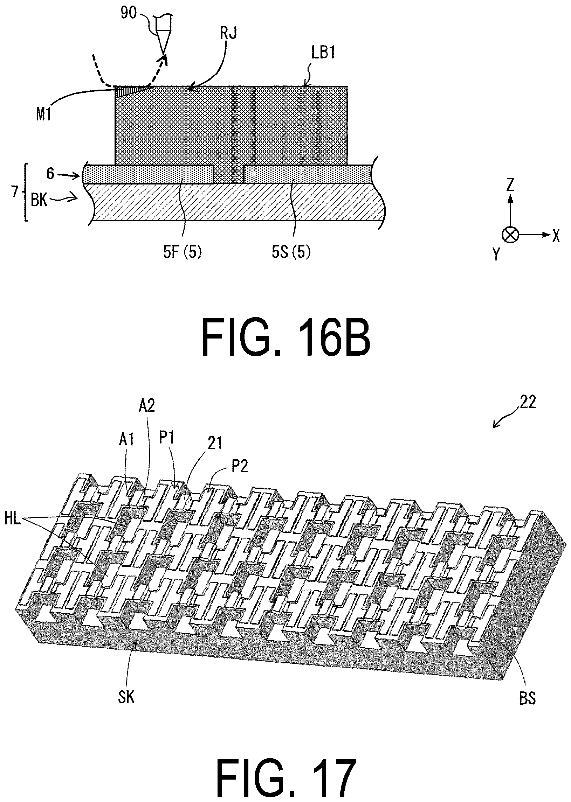

FIG. 16A and FIG. 16B are cross-sectional views illustrating an example of a method of scribing and cleaving the laminate body LB1. In FIG. 16A and FIG. 16B, since the second semiconductor part S2 is much thinner than the first semiconductor part S1, the cross section of the laminate body LB 1 is illustrated as a simple rectangular shape for making illustration clearer and easier (the ridge portion RJ is not illustrated). The track of the scribing tool 90 is indicated by using a dashed line.

As illustrated in FIG. 16A, the scribing tool 90 has such a track that the tip of the scribing tool 90 is inserted from the side surface of the laminate body LB1 and is taken out from the upper surface of the laminate body LB 1, which facilitates scribing of the laminate body LB1. When the interval (gap GP) between the second laminate body LB2 and the first laminate body LB 1 is, for example, 5 µm or more, the scribing tool 90 can be easily inserted into the side surface of the first laminate body LB1. As illustrated in FIG. 16B, the scribing tool 90 may scribe the laminate body LB 1 so as to pass through the upper surface of the laminate body LB 1. In this case, the scribing tool 90 may pass through the upper surface of the second semiconductor part S2. The scribing of the laminate body LB 1 may be performed on the second semiconductor part S2 or may be performed on the first semiconductor part S1.

### Transferring

Referring again to FIG. 13 and FIG. 14, according to Example 1, in the manufacturing method for the laser element, the laser bodies 21 are then transferred from the semiconductor substrate 10 including the plurality of laser bodies 21 to the support substrate SK. For example, some laser bodies 21 selected from the plurality of laser bodies 21 may be transferred from the template substrate 7 to the support substrate SK so as to straddle the plurality of laser bodies 21, such as every two or three laser bodies 21.

In Example 1, after the laser body 21 is formed, the growth suppressive part 5 (for example, a Si-based mask portion) may be removed by etching using hydrofluoric acid, buffered hydrofluoric acid (BHF), or the like. That is, the growth suppressive part 5 of the semiconductor substrate 10 may be removed before the transfer to the support substrate SK. This can facilitate separation of the laser body 21 from the template substrate 7. Since the semiconductor substrate 10 includes the gap GP, the growth suppressive part 5 is partially exposed. Therefore, the growth suppressive part 5 can be easily etched.

The semiconductor substrate 10 may be divided into an appropriate size by dicing or the like. For example, the semiconductor substrate 10 may be divided into small pieces having a square size of 10 mm. The support substrate SK may be divided into an appropriate size by dicing or the like. For example, the support substrate SK may be divided into small pieces having the square size of 10 mm so as to have the same size as those of the small pieces of the semiconductor substrate 10.

The support substrate SK only needs to be capable of transferring the laser body 21, and a specific configuration thereof is not particularly limited. An example will be described below.

FIG. 17 is a perspective view schematically illustrating the laser substrate 22 where the plurality of laser bodies 21 are bonded to the support substrate SK.

As illustrated in FIG. 17, the laser substrate 22 includes the support substrate SK and the plurality of laser bodies 21. In the laser substrate 22, the plurality of laser bodies 21 may be aligned in a matrix on the support substrate SK in a direction (the Y direction) defining the resonator lengths L1 and a direction (the X direction) orthogonal to the direction (the Y direction) such that the directions of the resonator lengths L1 are aligned, and the first pad portion P1 and second pad portion P2 and the first bonding portion A1 and second bonding portion A2 may be provided corresponding to each of the laser bodies 21.

After being transferred to the support substrate SK, the laser body 21 may be provided with the second electrode E2. The back surface of the laser body 21 (the back surface of the base semiconductor part 8) may be polished.

The support substrate SK can be formed, for example, by providing a Si substrate, a SiC substrate, or the like with a plurality of recessed parts HL (having a rectangular shape in plan view) in a matrix and providing non-recessed parts with a plurality of the first pad portions P 1, a plurality of the second pad portions P2, a plurality of the first bonding portions A1, and a plurality of the second bonding portions A2.

Formation of Reflector Film and Division of Laser Substrate The reflector film UF is formed on each of the resonator end surfaces F1 and F2 of the laser body 21. The reflector film UF is formed for reflectance adjustment, passivation, and the like. The reflector film UF may be formed by using the laser substrate 22 of a two-dimensional arrangement type, or the reflector film UF may be formed by dividing the laser substrate 22 into a bar shape and then using the formed laser substrate 22 having the bar shape.

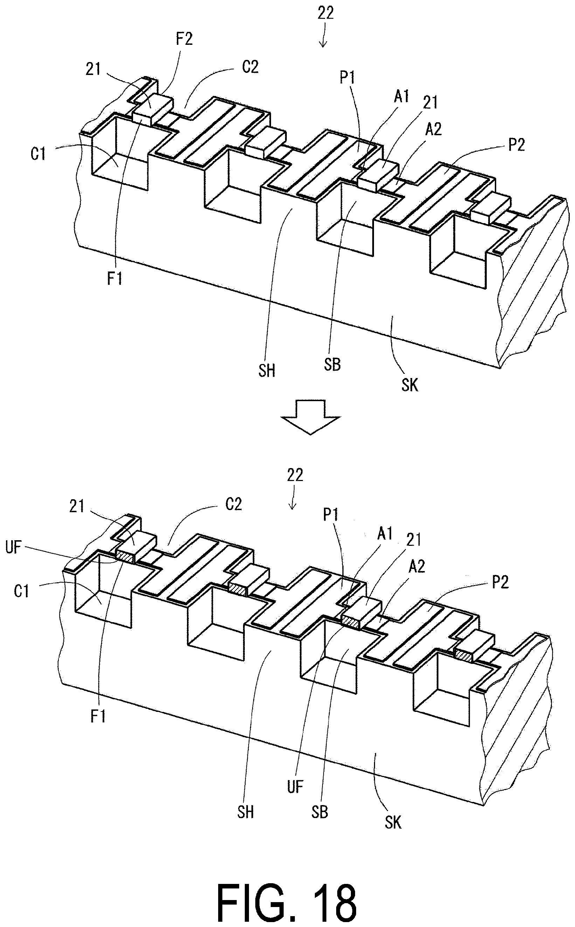

FIG. 18 is a perspective view illustrating an example of the divided laser substrate 22 having the bar shape. The laser substrate 22 of the two-dimensional arrangement type as illustrated in FIG. 17 can also be laterally divided (divided for each of rows extending in the X direction) to form the laser substrate 22 of a one-dimensional arrangement type (with a bar shape) as illustrated in FIG. 18. As described above, the support substrate SK may be divided into a plurality of pieces after the laser bodies 21 are transferred to the support substrate SK. The one-dimensional arrangement type facilitates forming the reflector film UF on each of the pair of resonator end surfaces F1 and F2.

Subsequently, the laser element 23 (see FIG. 12) including the laser body 21 and the support body ST can be formed by dividing the support substrate SK.

### Manufacturing Apparatus

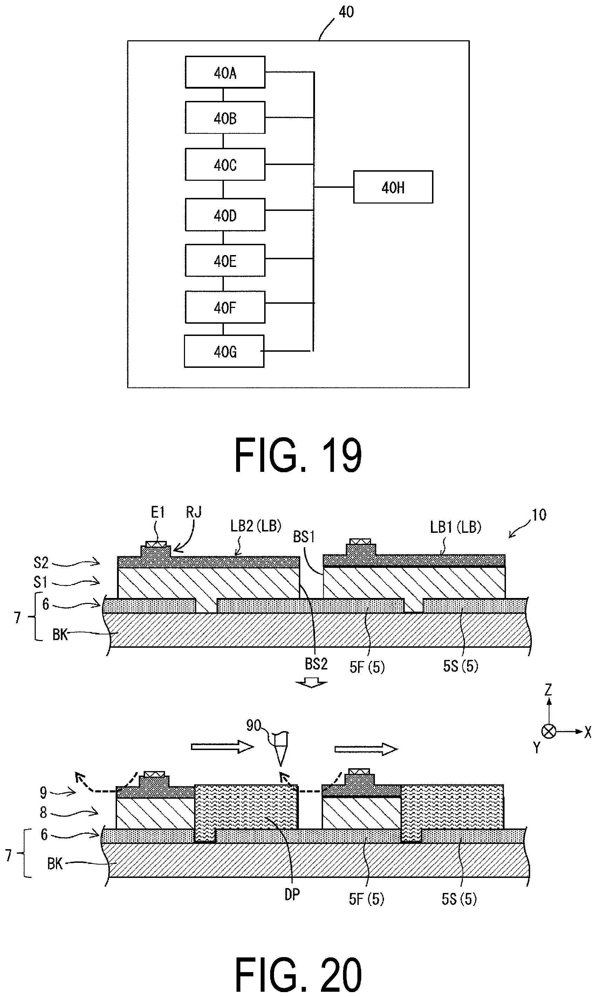

FIG. 19 is a block diagram illustrating a manufacturing apparatus for the laser element according to Example 1. As illustrated in FIG. 19, according to Example 1, the manufacturing method for the laser element can be achieved with a manufacturing apparatus 40 for the laser element. The manufacturing apparatus 40 executes each of steps. According to Example 1, the manufacturing apparatus 40 for the laser element may include an apparatus 40A that prepares the template substrate 7, an apparatus 40B that forms the first semiconductor part S1, an apparatus 40C that forms the second semiconductor part S2 including the ridge portion RJ, an apparatus 40D that forms the first electrode E1, an apparatus 40E that scribes the laminate body LB, an apparatus 40F that transfers the laser body 21 to the support substrate SK, an apparatus 40G that forms the reflector film UF on each of the pair of resonator end surfaces F1 and F2, and an apparatus 40H that controls the apparatuses 40A to 40G. For example, an MOCVD apparatus can be used for the apparatuses 40B and 40C. The apparatus 40B may be used as the apparatus 40C. For example, a sputtering apparatus can be used for the apparatus 40D. The apparatus 40E may include a photolithography apparatus. The apparatus 40H may include a processor and a memory. The apparatus 40H may be configured to control at least one of the apparatuses 40A to 40G by executing a program stored in a built-in memory, in a communicable external device, or on an accessible network, for example, and Example 1 also includes the program, and a recording medium, an external device, and the like storing the program therein.

When the template substrate 7 prepared in advance is used, the manufacturing apparatus 40 does not need to include the apparatus 40A. When the semiconductor substrate 10 in which the first semiconductor part S1 is formed on the template substrate 7 in advance is used, the manufacturing apparatus 40 does not need to include the apparatus 40A and the apparatus 40B.

### First Variation

### 1A

FIG. 20 is a side view schematically illustrating another example of the manufacturing method for the laser element according to Example 1. In Example 1, the second laminate body LB2 and the first laminate body LB1 are scribed by operating the scribing tool 90 in a direction from the second laminate body LB2 toward the first laminate body LB1. In another example of Example 1, the scribing tool 90 may be operated in a direction from the first laminate body LB1 toward the second laminate body LB2.

As illustrated in FIG. 20, the ridge portion RJ of the first laminate body LB1 is positioned on a side closer to the second laminate body LB2, and the ridge portion RJ of the second laminate body LB2 is positioned on a side farther from the first laminate body LB1. After scribing the second laminate body LB2, the scribing tool 90 is passed through the second laminate body LB2 and then passed through the first laminate body LB 1 to scribe the first laminate body LB1. At this time, the scribing tool 90 may be operated so as to be inserted from the upper surface of the first laminate body LB1 and to be taken out from the side surface BS1 closer to the ridge portion RJ. The scribing tool 90 may contact the damage portion DP formed by cleaving the second laminate body LB2. The scribing tool 90 may be inserted from the side surface BS2 of the second laminate body LB2 farther from the ridge portion RJ and be taken out from the upper surface of the second laminate body LB2.

### 1B

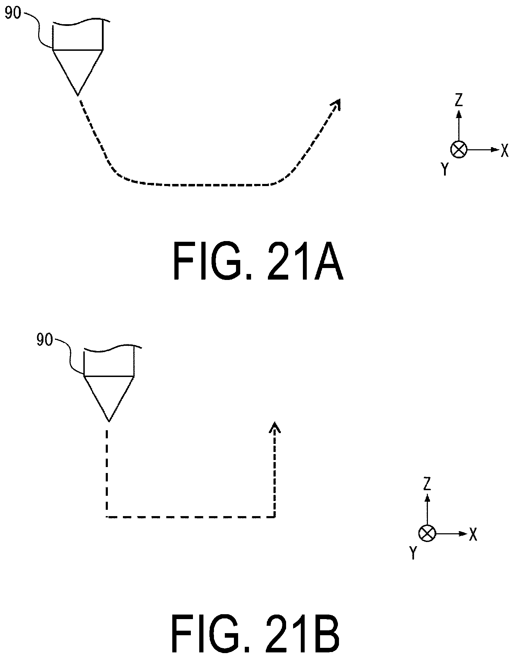

FIG. 21A and FIG. 21B are schematic views illustrating examples of the track of the scribing tool 90. As illustrated in FIG. 21A, the track of the scribing tool 90 may have a boat shape. For example, the track of the scribing tool 90 may be such that the scribing tool 90 obliquely moves downward in the X direction and the Z direction, moves in the X direction, and then obliquely moves upward in the X direction and the Z direction. In this case, the cleaving starting point can be narrowed. Therefore, the cleaving accuracy is improved. As a result, a yield of forming the laser body 21 can be improved.

As illustrated in FIG. 21B, the track of the scribing tool 90 may have a box shape. For example, the track of the scribing tool 90 may be such that the scribing tool 90 moves downward in the Z direction, moves in the X direction, and then moves upward in the Z direction. In this case, the scribing tool 90 can be easily inserted into the side surface of the first laminate body LB1 from a gap between the first laminate body LB1 and the second laminate body LB2. A scribing length can be easily shortened. As a result, the width of the laser body 21 can be reduced. Therefore, a relatively large number of laser bodies 21 can be easily formed from the semiconductor substrate 10.

### Example 2

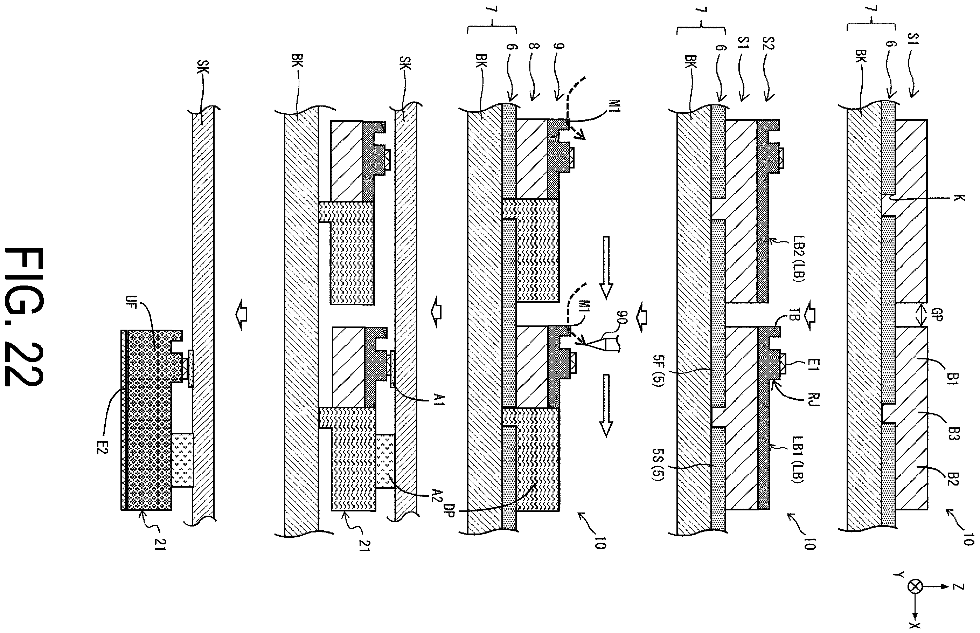

FIG. 22 is a cross-sectional view schematically illustrating a manufacturing method for a laser element according to Example 2.

Although an example in which the track of the scribing tool 90 does not pass through the ridge portion RJ has been described in Example 1, the scribing tool 90 may inevitably come into contact with the ridge portion RJ depending on a size of the gap GP, performance of the scriber, a position and a size of the ridge portion RJ, and the like.

In Example 2, as illustrated in FIG. 22, the second semiconductor part S2 includes a protruding portion TB positioned on an outer side relative to the ridge portion RJ. The protruding portion TB is scribed.

The protruding portion TB may have, for example, the same height as that of the ridge portion RJ. The laser body 21 may include the scribing mark M1 at the protruding portion TB. Accordingly, the possibility that the scribing tool 90 comes into contact with the ridge portion RJ can be effectively reduced. Thus, the scribing tool 90 can scribe the laminate body LB. In this case, the scribing tool 90 can be made to be less likely to contact the damage portion DP of the second laminate body LB2.

Subsequent steps are the same as or similar to those in Example 1 described above.

### Example 3

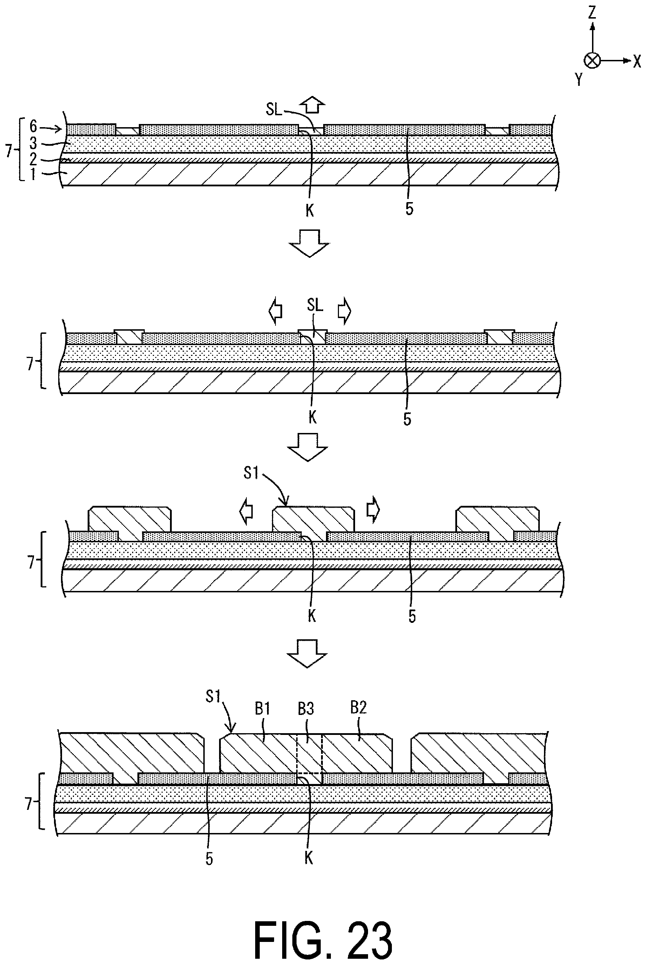

FIG. 23 is a cross-sectional view illustrating an example of lateral growth of the first semiconductor part (ELO semiconductor layer). FIG. 24 is a cross-sectional view schematically illustrating a manufacturing method for a laser element in Example 3.

As illustrated in FIG. 23, an initial growth portion SL is formed on the seed portion 3 (GaN layer of the upper layer part) exposed from the opening portion K, and then the first semiconductor part S1 may be laterally grown from the initial growth portion SL. The initial growth portion SL serves as a starting point of the lateral growth of the first semiconductor part S 1. The first semiconductor part S1 may be controlled to grow in the Z direction (c-axis direction) or in the X direction (a-axis direction) by appropriately controlling the ELO film formation conditions.

Here, the film formation of the initial growth portion SL may be stopped just before an edge of the initial growth portion SL rides up to the upper surface of the growth suppressive part 5 (at a timing when the edge is in contact with the top edge of a side surface of the growth suppressive part 5) or just after the edge rides up to the upper surface of the growth suppressive part 5 (that is, the ELO film formation conditions may be switched from film formation conditions in the c-axis direction to film formation conditions in the a-axis direction at this timing). In this way, lateral film formation is performed with the initial growth portion SL slightly protruding from the growth suppressive part 5, reducing the amount of the material consumed for growth in the thickness direction of the first semiconductor part S1 and allowing the first semiconductor part S1 to be laterally grown at a high speed. The initial growth portion SL may have a thickness of, for example, 0.5 µm or more and 4.0 µm or less.

In Example 3, as illustrated in FIG. 24, the first semiconductor part S1 in the first laminate body LB 1 may include, on a side surface closer to the ridge portion RJ, a first surface BS11 on a bottom side and a second surface BS12 on a top side, and the second surface BS12 may be inclined toward the ridge portion RJ.

This makes it possible to ensure a wide portion through which the scribing tool 90 passes in a space between the first laminate body LB1 and the second laminate body LB2. Therefore, when the scribing tool 90 obliquely scribes the first laminate body LB1, the scribing tool 90 can be easily taken out from the upper surface of the first laminate body LB1 at a position relatively far from the ridge portion RJ. Accordingly, the possibility that the scribing tool 90 comes into contact with the ridge portion RJ can be effectively reduced. Thus, the scribing tool 90 can scribe the laminate body LB. In this case, the scribing tool 90 can be made to be less likely to contact the damage portion DP of the second laminate body LB2.

In Example 3, as illustrated in FIG. 24, the first growth suppressive part 5F and the second growth suppressive part 5S are removed before the scribing. Since the first semiconductor part S1 and the base substrate BK are chemically bonded to each other at the opening portion K, the first laminate body LB1 and the second laminate body LB2 can be scribed even when the growth suppressive part 5 (mask portion) is removed. The same applies to the other examples.

Subsequent steps are the same as or similar to those in Example 1 described above.

### Example 4

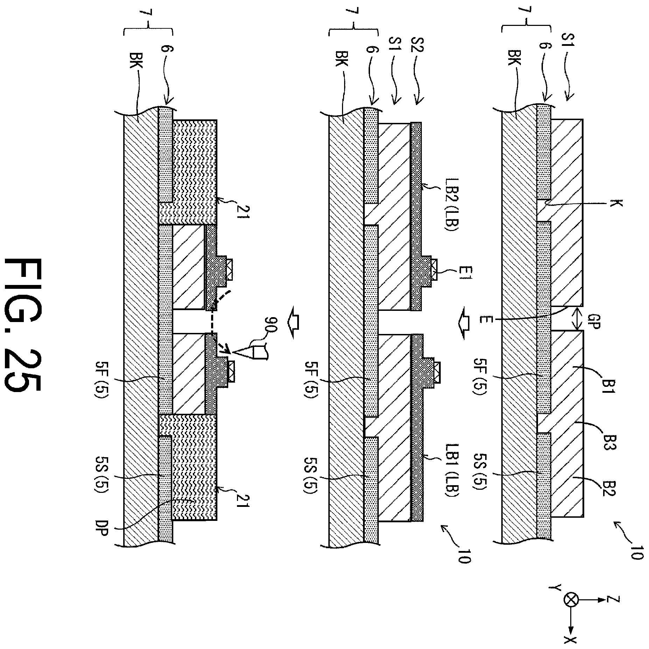

FIG. 25 is a cross-sectional view schematically illustrating a manufacturing method for a laser element in Example 4.

In Examples 1 to 3, the second laminate body LB2 was scribed and then the first laminate body LB 1 was scribed. On the other hand, in Example 4, the second laminate body LB2 and the first laminate body LB1 may be simultaneously scribed.

In Example 4, as illustrated in FIG. 25, the ridge portion RJ of the first laminate body LB1 is positioned on a side close to the second laminate body LB2, and the ridge portion RJ of the second laminate body LB2 is positioned on a side close to the first laminate body LB1. The first laminate body LB1 and second laminate body LB2 are scribed by passing the scribing tool 90 through the second laminate body LB2 and then through the first laminate body LB1. This can cleave the second laminate body LB2 and the first laminate body LB1.

Subsequent steps are the same as or similar to those in Example 1 described above.

### Example 5

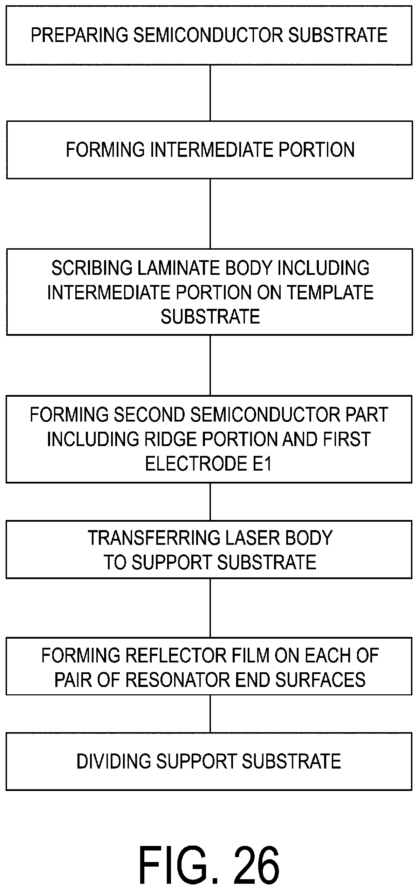

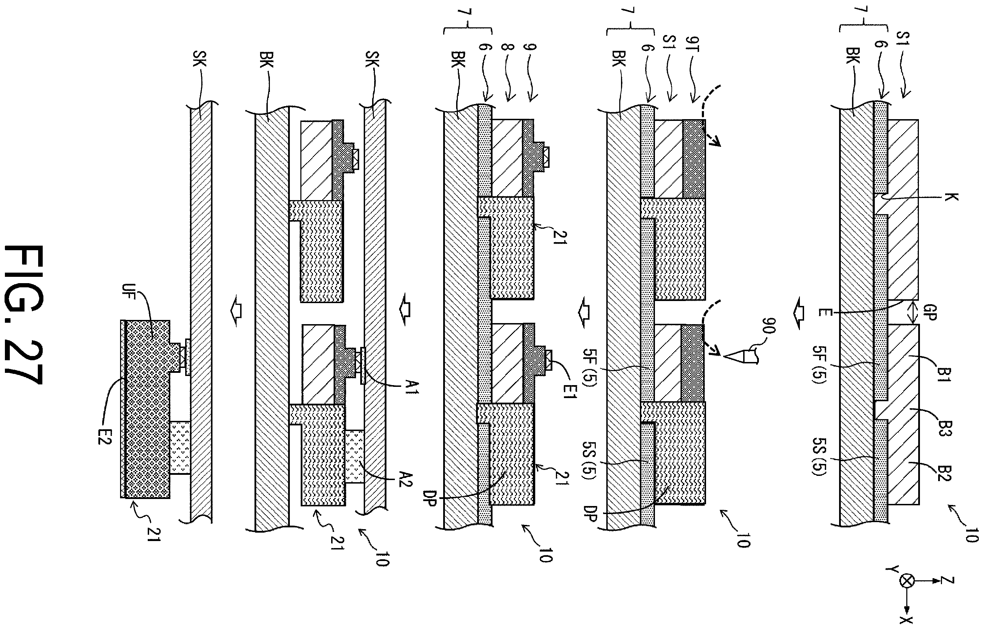

FIG. 26 is a flowchart schematically illustrating a manufacturing method for a laser element in Example 5. FIG. 27 is a cross-sectional view schematically illustrating the manufacturing method for the laser element in Example 5.

As illustrated in FIG. 26 and FIG. 27, in Example 5, first, the semiconductor substrate 10 is prepared. The semiconductor substrate 10 includes the base substrate BK, the first growth suppressive part 5F and the second growth suppressive part 5S adjacent to each other with the opening portion K interposed therebetween, and the first semiconductor part S 1 having a longitudinal shape and positioned on the first growth suppressive part 5F and the second growth suppressive part 5S from the opening portion K. Then, the intermediate portion 9T including the active section 9K is formed on the first semiconductor part S1, and the first laminate body LB 1 including the first semiconductor part S1 and the intermediate portion 9T is scribed at a portion positioned on the first growth suppressive part 5F. Thereafter, the ridge portion RJ positioned above the first growth suppressive part 5F is formed on the upper layer side relative to the active section 9K.

The intermediate portion 9T may include the first contact portion 9A, the first cladding portion 9B, the first optical guiding portion 9C, the active section 9K, the second optical guiding portion 9D, the electron blocking portion 9E, and the second cladding portion 9F. Scribing the first laminate body LB 1 including the first semiconductor part S1 and the intermediate portion 9T may cause occurrence of the damage portion DP at the cleaved end surface. On the other hand, the damage portion DP is not generated in the portion positioned on the first growth suppressive part 5F.

In Example 5, the ridge portion RJ and the first electrode E1 are formed in the portion positioned on the first growth suppressive part 5F. Thus, the optical resonator LK can be formed without being affected by the damage portion DP.

Subsequent steps are the same as or similar to those in Example 1 described above.

### Example 6

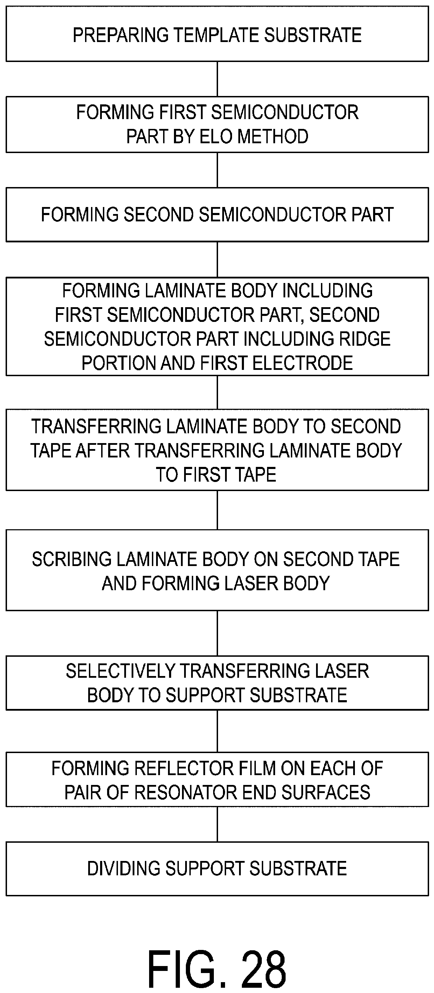

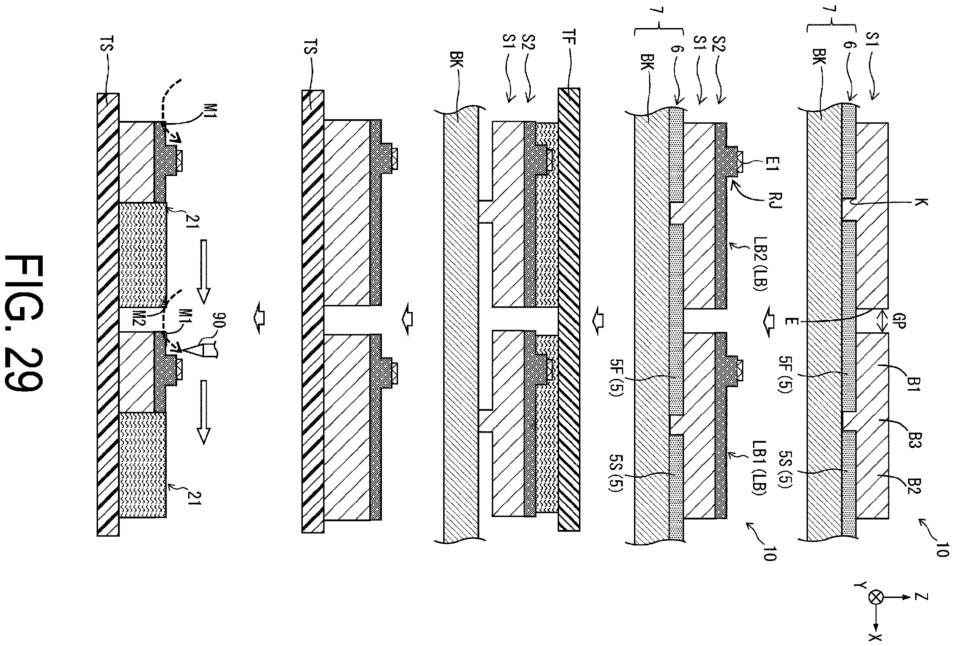

FIG. 28 is a flowchart schematically illustrating a manufacturing method for a laser element in Example 6. FIG. 29 is a cross-sectional view schematically illustrating the manufacturing method for the laser element in Example 6.

As illustrated in FIG. 28 and FIG. 29, according to Example 6, in the manufacturing method for the laser element, after the semiconductor substrate 10 including the laminate body LB is prepared, the first laminate body LB 1 including the first semiconductor part S 1 and the second semiconductor part S2 is once transferred to a first tape TF and then transferred again to a second tape TS. The laminate body LB is scribed on the second tape TS.

For example, the growth suppressive part 5 (mask portion) may be removed by etching after the formation of the laminate body LB, and the laminate body LB may be transferred to the first tape TF having adhesiveness. Thus, the first semiconductor part S1 is separated from the base substrate BK. The back surface of the first semiconductor part S1 in the laminate body LB may be polished. The laminate body LB may be adhered to the second tape TS, and the laminate body LB may be transferred from the first tape TF to the second tape TS.

Then, the laminate body LB may be scribed on the second tape TS to form the laser body 21 including the pair of resonator end surfaces F1 and F2. Subsequently, the laser body 21 on the second tape TS is bonded to the support substrate SK. This forms the two-dimensional arrangement type of the laser substrate 22 (see FIG. 17). Next, the two-dimensional arrangement type of the laser substrate 22 is divided for each row to form the one-dimensional arrangement type of the laser substrate 22 (having a bar shape) (see FIG. 18). Next, the reflector film UF is formed on each of the resonator end surfaces F1 and F2 of the one-dimensional arrangement type of the laser substrate 22. Thereafter, the support substrate SK is divided into the plurality of support bodies ST, and each of the support bodies ST is caused to hold one or more laser bodies 21, thereby forming the plurality of laser elements 23 (see FIG. 12). Each of the laser bodies 21 is held by the support body ST in the junction-down manner (mounting form in which the ridge portion RJ is positioned on the support body ST side).

As a base member of the first tape TF, a material such as PET can be used. As a base member of the second tape TS, a material such as polyimide can be used. The base members of the first tape TF and second tape TS may be made of the same material or may be made of different materials.

In Example 6, the laminate body LB is divided on the second tape TS, but the present disclosure is not limited to this. The laminate body LB may be cleaved by forming a cleaving starting point in advance in the laminate body LB by scribing or the like, and applying stress to the laminate body LB from the back surface of a third tape through the third tape by using a blade for breaking or the like with the laminate body LB held on the first tape TF being in contact with the third tape. In this case, the base member of the first tape TF may be made of a material having a Young's modulus larger than that of the third tape. In this manner, deformation of the first tape TF when the laminate body LB is cleaved can be reduced, and positional deviation of the laminate body LB can be suppressed. On the other hand, since the third tape is more flexible than the first tape TF, for example, when stress is applied to the laminate body LB by using the blade for breaking, the third tape easily follows a shape of the blade for breaking, and stress can be applied to a more concentrated range. Accordingly, the laminate body LB is easily cleaved.

The base member of the third tape can be made of, for example, polyolefin. The Young's modulus of the first tape TF may be, for example, equal to or greater than 2000 MPa, and the Young's modulus of the third tape may be, for example, equal to or less than 1500 MPa.

### Example 7

Hereinafter, the laser body 21, the laser substrate (semiconductor laser array) 22, the laser element (semiconductor laser element) 23, and a semiconductor laser module may be collectively referred to as a semiconductor laser device (semiconductor laser device). The semiconductor laser module (not illustrated) may be, for example, a surface mount type package, and may include a housing and the laser element 23. The semiconductor laser module may be, for example, a TO-CAN mount type package, and may include a stem and the laser element 23.

An electronic device including a semiconductor laser device, and a controller that includes a processor and that controls the semiconductor laser device falls within the scope of the present disclosure. Examples of the electronic device include a lighting device, a display device, a communication device, an information processing device, a medical device, and an electric vehicle (EV).

### Example 8

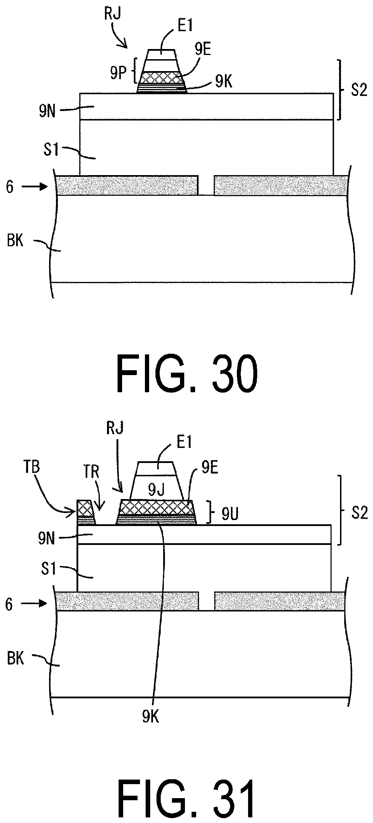

FIG. 30 and FIG. 31 are cross-sectional views schematically illustrating a manufacturing method for a laser element in Example 8. As illustrated in FIG. 30, the second semiconductor part S2 may include an electron blocking layer 9E, and the ridge portion RJ may include the electron blocking layer 9E. The ridge portion RJ may include the active layer (active section) 9K. As illustrated in FIG. 31, the second semiconductor part S2 including the electron blocking layer 9E may include the protruding portion TB positioned on an outer side than the ridge portion RJ. A trench TR penetrating through the electron blocking layer 9E may be formed between the protruding portion TB and the ridge portion RJ. The ridge portion RJ may include a lower portion 9U including the electron blocking layer 9E and an upper portion 9J narrower in width than the lower portion 9U. The lower portion 9U may include the active layer 9K. According to Example 8, the flatness of the cleaved end surface could be enhanced. This is considered to be because scratches are likely to be generated at interfaces where compositions of the electron blocking layer 9E, the active layer 9K, and the like change. The flatness of the cleaved end surface can also be enhanced by gradation of the aluminum composition of the electron blocking layer 9E, or by increasing the film thickness while decreasing the aluminum composition of the electron blocking layer 9E.

### Supplementary Note

In the present disclosure, the invention has been described above based on the various drawings and examples. However, the invention according to the present disclosure is not limited to the embodiments and examples described above. That is, the embodiments of the invention according to the present disclosure can be modified in various ways within the scope illustrated in the present disclosure, and embodiments obtained by appropriately combining the technical means disclosed in different embodiments and examples are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

5 Growth suppressive part (mask portion)
6 Growth control pattern (mask pattern)
7 Template substrate
10 Semiconductor substrate
21 Laser body
22 Laser substrate
23 Laser element
90 Scribing tool
F1, F2 Resonator end surface
BK Base substrate
K Opening portion
LB1 First laminate body
LB2 Second laminate body
S1 First semiconductor part
S2 Second semiconductor part
SK Support substrate

## Claims

1. A manufacturing method for a laser element, comprising the steps of:
preparing a semiconductor substrate comprising a base substrate, a first growth suppressive part and a second growth suppressive part adjacent to each other with an opening portion interposed between the first growth suppressive part and the second growth suppressive part, and a first semiconductor part having a longitudinal shape, the first semiconductor part being positioned on the first growth suppressive part and the second growth suppressive part from the opening portion;
forming a second semiconductor part on the first semiconductor part, the second semiconductor part comprising a ridge portion positioned above the first growth suppressive part; and
scribing a portion of a first laminate body comprising the first semiconductor part and the second semiconductor part on a side where the ridge portion is positioned.

2. The manufacturing method for a laser element, according to claim 1,
wherein cleaving of the first laminate body spontaneously proceeds when the scribing is performed.

3. The manufacturing method for a laser element, according to claim 2,
wherein the cleaving is performed on the base substrate without dividing the base substrate.

4. The manufacturing method for a laser element, according to any one of claims 1 to 3,
wherein the second semiconductor part comprises an active layer, and
the ridge portion is positioned on an upper layer side relative to the active layer.

5. The manufacturing method for a laser element, according to any one of claims 1 to 4,
wherein a scribing tool is inserted from a side surface closer to the ridge portion among two side surfaces of the first laminate body along a longitudinal direction of the first laminate body.

6. The manufacturing method for a laser element, according to claim 5,
wherein the scribing tool is taken out from an upper surface of the first laminate body.

7. The manufacturing method for a laser element, according to claim 6,
wherein a position where the scribing tool is taken out is on an outer side relative to the ridge portion.

8. The manufacturing method for a laser element, according to claim 7,
wherein the position where the scribing tool is taken out is at a distance of 3 µm or less from the side surface closer to the ridge portion.

9. The manufacturing method for a laser element, according to claim 5,
wherein the side surface closer to the ridge portion comprises a first surface on a bottom side and a second surface on a top side, and the second surface is inclined toward the ridge portion.

10. The manufacturing method for a laser element, according to any one of claims 1 to 9,
wherein the scribing is performed on the second semiconductor part.

11. The manufacturing method for a laser element, according to any one of claims 1 to 10,
wherein the second semiconductor part comprises a protruding portion positioned on an outer side relative to the ridge portion, and
scribing is performed on the protruding portion.

12. The manufacturing method for a laser element, according to any one of claims 1 to 11,
wherein the first growth suppressive part and the second growth suppressive part are aligned in a first direction, and
a second laminate body comprising a ridge portion and being adjacent to the first laminate body in the first direction is formed.

13. The manufacturing method for a laser element, according to claim 12,
wherein the second laminate body is formed at a distance of 5 µm or more from the first laminate body.

14. The manufacturing method for a laser element, according to claim 12,
wherein the ridge portion of the first laminate body is positioned on a side close to the second laminate body, and the ridge portion of the second laminate body is positioned on a side far from the first laminate body, and
after scribing of the second laminate body is performed, a scribing tool is passed through the second laminate body and then passed through the first laminate body, and thus, the scribing of the first laminate body is performed.

15. The manufacturing method for a laser element, according to claim 12,
wherein the ridge portion of the first laminate body is positioned on a side close to the second laminate body, and the ridge portion of the second laminate body is positioned on a side close to the first laminate body, and
a scribing tool is passed through the second laminate body and then passed through the first laminate body, and thus, scribing of the first laminate body and the second laminate body is performed.

16. The manufacturing method for a laser element, according to any one of claims 1 to 15,
wherein a track of a scribing tool is a boat shape.

17. The manufacturing method for a laser element, according to any one of claims 1 to 15,
wherein a track of a scribing tool is a box shape.

18. The manufacturing method for a laser element, according to any one of claims 1 to 17,
wherein the scribing is performed by using a diamond scriber.

19. The manufacturing method for a laser element, according to any one of claims 1 to 18,
wherein the ridge portion comprises a cladding layer and a contact layer.

20. The manufacturing method for a laser element, according to any one of claims 1 to 19,
the ridge portion has a ridge shape extending in a longitudinal direction of the first semiconductor part.

21. The manufacturing method for a laser element, according to claim 10,
wherein the second semiconductor part comprises a nitride semiconductor, and
a direction of a force applied to the second semiconductor part by a scribing tool is parallel to an m-plane of the second semiconductor part.

22. The manufacturing method for a laser element, according to any one of claims 1 to 21,
wherein the first semiconductor part comprises a GaN-based semiconductor, and
the first growth suppressive part and the second growth suppressive part are aligned in a <11-20> direction of the GaN-based semiconductor.

23. The manufacturing method for a laser element, according to claim 2,
wherein a plurality of anodes aligned in a longitudinal direction of the first semiconductor part are formed on the ridge portion before the scribing, and
a cleaved surface generated by the scribing does not intersect any of the plurality of anodes.

24. The manufacturing method for a laser element, according to any one of claims 1 to 23,
wherein the first growth suppressive part and the second growth suppressive part are removed before the scribing is performed.

25. The manufacturing method for a laser element, according to claim 1,
wherein the first laminate body comprising the first semiconductor part and the second semiconductor part is once transferred to a first tape and then, the first laminate body is transferred again to a second tape, and
the scribing is performed on the second tape.

26. The manufacturing method for a laser element, according to any one of claims 1 to 25,
wherein the base substrate comprises a silicon substrate, and
the first semiconductor part comprises a GaN-based semiconductor.

27. The manufacturing method for a laser element, according to claim 1,
wherein the second semiconductor part comprises an electron blocking layer, and
the ridge portion comprises the electron blocking layer.

28. The manufacturing method for a laser element, according to claim 11,
wherein the second semiconductor part comprises an electron blocking layer,
a trench penetrating through the electron blocking layer is formed between the protruding portion and the ridge portion, and
the ridge portion comprises a lower portion comprising the electron blocking layer and an upper portion having a width narrower than a width of the lower portion.

29. A manufacturing method for a laser element, comprising the steps of:
preparing a semiconductor substrate comprising a base substrate, a first growth suppressive part and a second growth suppressive part adjacent to each other with an opening portion interposed between the first growth suppressive part and the second growth suppressive part, and a first semiconductor part having a longitudinal shape, the first semiconductor part being positioned on the first growth suppressive part and the second growth suppressive part from the opening portion;
forming an intermediate portion comprising an active layer, on the first semiconductor part;
scribing a portion of a laminate body comprising the first semiconductor part and the intermediate portion, the portion being positioned on the first growth suppressive part; and
forming a ridge portion positioned above the first growth suppressive part on an upper layer side relative to the active layer.

30. The manufacturing method for a laser element, according to any one of claims 1 to 29,
wherein the first growth suppressive part and the second growth suppressive part are a first mask portion and a second mask portion adjacent to each other with the opening portion interposed between the first mask portion and the second mask portion.

31. A manufacturing apparatus for a laser element, the manufacturing apparatus being configured to perform the steps according to claim 1 or 29.

32. A laser element comprising:
a base semiconductor part; and
a compound semiconductor part positioned on the base semiconductor part, the compound semiconductor part comprising an active section,
wherein the base semiconductor part comprises a first portion, a second portion, and a third portion positioned between the first portion and the second portion,
the compound semiconductor part comprises a ridge portion positioned above the first portion, and
a scribing mark is provided in a portion on a side where the ridge portion is positioned.

33. The laser element according to claim 32,
wherein the compound semiconductor part comprises the scribing mark.

34. The laser element according to claim 32 or 33,
wherein the third portion has a threading dislocation density higher than threading dislocation densities of the first portion and the second portion.

35. The laser element according to any one of claims 32 to 34,
wherein the base semiconductor part and the compound semiconductor part comprise a GaN-based semiconductor, and
the compound semiconductor part comprises a resonator end surface being an m-plane.

36. The laser element according to any one of claims 32 to 35,
wherein the second portion comprises a linear scratch extending from the third portion.

37. An electronic device comprising:
the laser element according to any one of claims 32 to 36.
